# EUROPEAN PATENT APPLICATION

(11) **EP 2 348 802 A2**
(43) Date of publication of application: **27.07.2011**
(21) Application number: 11151269.5
(22) Date of filing: 18.01.2011
(51) Int. Cl.: H05K 7/20

(54) **Backflow prevention device, electronic apparatus, and method for producing backflow prevention device**

(30) Priority: 20.01.2010 JP 2010010530
(71) Applicant: Fujitsu Limited, Kawasaki-shi, Kanagawa 211-8588 (JP)
(72) Inventor: Sato, Yoichi, Kawasaki-shi Kanagawa 211-8588 (JP); Nishiyama, Takeshi, Kawasaki-shi Kanagawa 211-8588 (JP)
(74) Representative: Fenlon, Christine Lesley

(57) **Abstract**

A backflow prevention device (20) is disposed between a heat-generating component (1c) that generates heat and an air supply unit (6) for supplying air to the heat-generating component (1c). The backflow prevention device (20) includes a plurality of flaps (30) to be opened by airflow supplied from the air supply unit (6) and to be closed by gravity when the airflow stops; a frame case (21) that rotatably supports the plurality of flaps (30); and a connecting member (40) that connects between the plurality of flaps (30).

## Description

### FIELD

The embodiments discussed herein are directed to a backflow prevention device, an electronic apparatus, and a method for producing a backflow prevention device.

### BACKGROUND

Electronic apparatuses such as servers have conventionally incorporated a cooling device with a plurality of cooling fans for providing cooling to other devices and components in the apparatus. Such a cooling apparatus provides control to the RPM of the cooling fans in response to an ambient temperature and the amount of heat generated in the apparatus in order to save power consumption.

When one of the plurality of cooling fans provided in the server has failed, a drop in the amount and the pressure of airflow (cooling capacity) through the failed cooling fan is desired to be prevented. To this end, control is provided to allow the remaining functional cooling fans to operate at higher speeds, thereby preventing degradation in the cooling capacity.

Furthermore, the apparatus is also provided with a backflow prevention device for preventing the surrounding air from being drawn backwards through the air channel of a failed cooling fan during cooling fan failure. The backflow prevention device is provided vertically with a plurality of flaps that are opened and closed inside the frame case. When a cooling fan has failed, the plurality of flaps is closed due to gravity, thereby preventing backward airflow from the surrounding air.

The aforementioned conventional backflow prevention device employed a heavy flap in order to prevent the flap from vibrating or fluttering due to the amount and the pressure of airflow supplied by the cooling fan.

However, in the case of the flap formed of a heavy plate material, the flap itself can resist airflow and thus be responsible for a drop in cooling efficiency. In this context, flaps reduced in weight have been employed for the backflow prevention device. However, the light-weight flap can be reduced in flow resistance, but readily vibrated due to slow airflow. This vibration then leads to vibration noises and collision noises caused by the flaps colliding with the frame case.

Furthermore, in fabricating the aforementioned conventional backflow prevention device, the shaft portions of the plurality of flaps are rotatably incorporated in the frame case. Here, the flap to be used for the backflow prevention device is made in a mold having a flat molding region by filling and hardening a plastic material in the molding region.

Accordingly, it has been conventionally necessary to distinguish between the front and rear side of the flap before the flap is incorporated into the frame case. This may lead to errors during assembling the flap, and an increase in the number of flaps assembled can increase the number of fabrication steps.

Accordingly, it is desirable to provide a backflow prevention device, an electronic apparatus, and a method for producing a backflow prevention device, which can prevent vibration noises caused by flaps vibrating or abutting against each other and collision noises made by flaps colliding with the frame case.
Patent Document 1: Japanese Utility Model Registration No. 3130935
Patent Document 2: Japanese Laid-open Patent Publication No. 03-175482
Patent Document 3: Japanese Laid-open Patent Publication No. 2007-158205

### SUMMARY

According to an aspect of an embodiment of the invention, a backflow prevention device disposed between a heat-generating component that generates heat and an air supply unit for supplying air to the heat-generating component includes a plurality of flaps to be opened by airflow supplied from the air supply unit and to be closed by gravity when the airflow stops; a frame case that rotatably supports the plurality of flaps; and a connecting member that connects between the plurality of flaps.

### BRIEF DESCRIPTION OF DRAWINGS

FIG. 1 is a view illustrating the inside of a backflow prevention device according to a first embodiment;
FIG. 2 is a perspective view illustrating the shape of flaps;
FIG. 3 is a perspective view illustrating the shape of a connecting member;
FIG. 4A is a perspective view illustrating flaps being opened;
FIG. 4B is a perspective view illustrating flaps being closed;
FIG. 4C is a perspective view illustrating flaps being half opened;
FIG. 5A is a perspective view illustrating the configuration of an electronic apparatus according to an example of the first embodiment;
FIG. 5B is a block diagram illustrating the configuration of an electronic apparatus according to an example of the first embodiment;
FIG. 6 is a view illustrating the inside of a backflow prevention device according to a second embodiment;
FIG. 7 is a perspective view illustrating the shape of flaps;
FIG. 8 is a perspective view illustrating the shape of a connecting member;
FIG. 9A is a perspective view illustrating flaps being opened;
FIG. 9B is a perspective view illustrating flaps being closed;
FIG. 9C is a perspective view illustrating flaps being half opened;
FIG. 10 is a view illustrating the inside of a backflow prevention device according to a third embodiment;
FIG. 11 is a perspective view illustrating the shape of a connecting member;
FIG. 12A is a perspective view illustrating flaps being opened;
FIG. 12B is a perspective view illustrating flaps being closed;
FIG. 12C is a perspective view illustrating flaps being half opened;
FIG. 13 is a view illustrating the inside of a backflow prevention device according to a fourth embodiment;
FIG. 14A is a perspective view illustrating flaps being opened;
FIG. 14B is a perspective view illustrating flaps being closed;
FIG. 14C is a perspective view illustrating flaps being half opened;
FIG. 15 is a view illustrating the inside of a backflow prevention device according to a fifth embodiment;
FIG. 16 is a perspective view illustrating a flap;
FIG. 17 is a plan view illustrating a flap;
FIG. 18A is a cross sectional view taken along A-A of FIG. 17;
FIG. 18B is a cross sectional view taken along B-B of FIG. 17;
FIG. 18C is a cross sectional view taken along C-C of FIG. 17;
FIG. 18D is a cross sectional view taken along D-D of FIG. 17;
FIG. 18E is a cross sectional view taken along E-E of FIG. 17;
FIG. 19 is a plan view illustrating the shape of a connecting member;
FIG. 20 is a perspective view illustrating an electronic apparatus according to a fifth embodiment;
FIG. 21 is a perspective view illustrating the fabricated structure of a backflow prevention device;
FIG. 22 is an enlarged view of the portion A of FIG. 21;
FIG. 23 is a perspective view illustrating a flap assembly;
FIG. 24 is a perspective view illustrating a first frame case;
FIG. 25 is a perspective view illustrating a second frame case;
FIG. 26 is an exploded perspective view illustrating the fabricated structure of a backflow prevention device;
FIG. 27 is a perspective view illustrating a method for producing a backflow prevention device;
FIG. 28 is a perspective view illustrating the fabricated structure of a backflow prevention device;
FIG. 29 is an exploded perspective view illustrating the fabricated structure of a backflow prevention device;
FIG. 30A is a perspective view illustrating a flap assembly;
FIG. 30B is an enlarged sectional view illustrating the part B of FIG. 30A;
FIG. 31 is a perspective view illustrating a method for producing a backflow prevention device;
FIG. 32 is a perspective view illustrating the fabricated structure of a backflow prevention device;
FIG. 33 is a perspective view illustrating the fabricated structure of a backflow prevention device;
FIG. 34 is a perspective view illustrating the fabricated structure of a backflow prevention device;
FIG. 35 is side view illustrating the outer appearance of a backflow prevention device;
FIG. 36A is a view illustrating the position of a flap when being fabricated;
FIG. 36B is a view illustrating the position of a flap when being opened;
FIG. 36C is a view illustrating the position of a flap when being closed;
FIG. 37A is an enlarged view illustrating the portion P of FIG. 36A;
FIG. 37B is an enlarged view illustrating the portion P of FIG. 36B;
FIG. 37C is an enlarged view illustrating the portion P of FIG. 36C;
FIG. 38 is an exploded perspective view illustrating the molded structure of a backflow prevention device;
FIG. 39 is an exploded perspective view illustrating the molded structure of a backflow prevention device;
FIG. 40 is an explanatory flowchart of the steps of a method for producing a backflow prevention device;
FIG. 41A is an explanatory view illustrating a method for producing a backflow prevention device;
FIG. 41B is an explanatory view illustrating a method for producing a backflow prevention device;
FIG. 41C is a cross sectional view illustrating the shape of a flap assembly;
FIG. 41D is a cross sectional view illustrating the shape of a flap assembly;
FIG. 42A is an explanatory view illustrating a conventional cooling apparatus;
FIG. 42B is an explanatory view illustrating a cooling apparatus when a cooling fan has failed;
FIG. 43 is an explanatory view illustrating a cooling apparatus with a conventional backflow prevention device;
FIG. 44A is a cross sectional view illustrating the inside of a backflow prevention device;
FIG. 44B is a cross sectional view illustrating the inside of a cooling apparatus;
FIG. 45A is a perspective view illustrating the inside of a backflow prevention device;
FIG. 45B is a cross sectional view illustrating the inside of a cooling apparatus;
FIG. 46A is a perspective view illustrating the inside of a backflow prevention device;
FIG. 46B is a cross sectional view illustrating the inside of a cooling apparatus; and
FIG. 47 is an explanatory view illustrating a method for producing a conventional backflow prevention device.

### DESCRIPTION OF EMBODIMENTS

Preferred embodiments of the present invention will be explained with reference to accompanying drawings.

### [a] First Embodiment

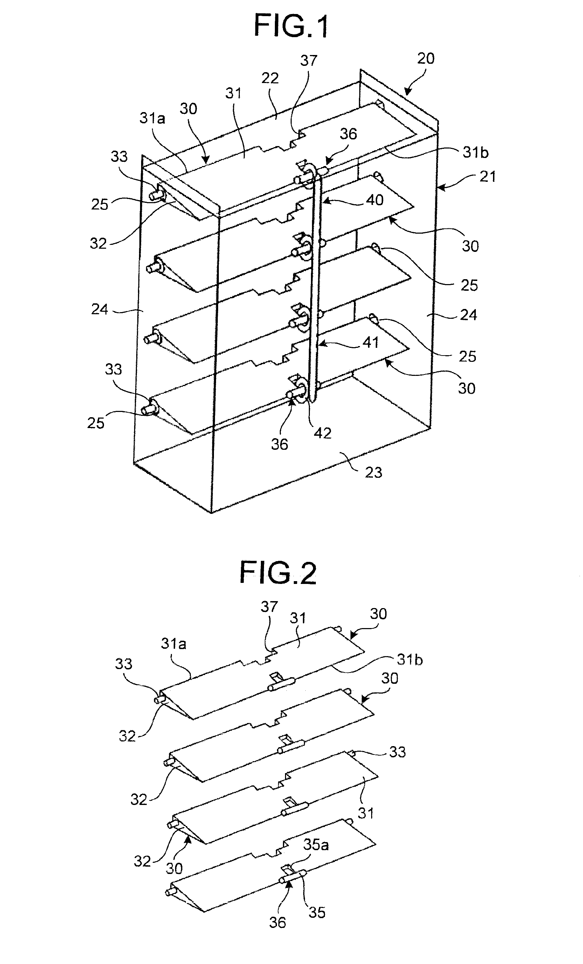

A backflow prevention device, an electronic apparatus, and a method for producing a backflow prevention device disclosed herein will be described below in more detail with reference to the accompanying drawings in accordance with the preferred embodiments. FIG. 1 is a view illustrating the inside of the backflow prevention device according to a first embodiment. FIG. 2 is a perspective view illustrating the shape of flaps of the backflow prevention device.

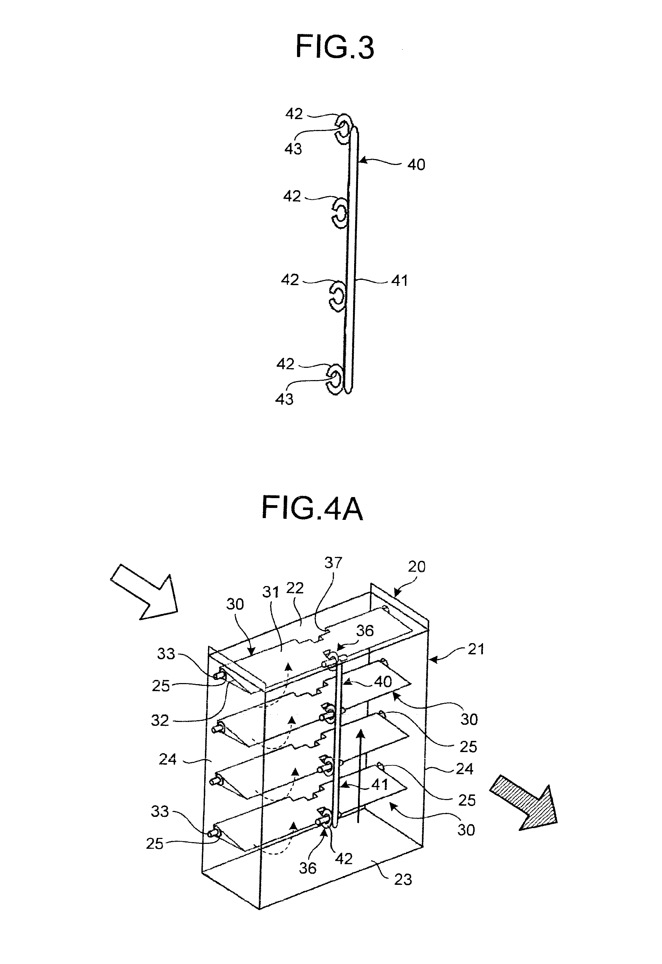

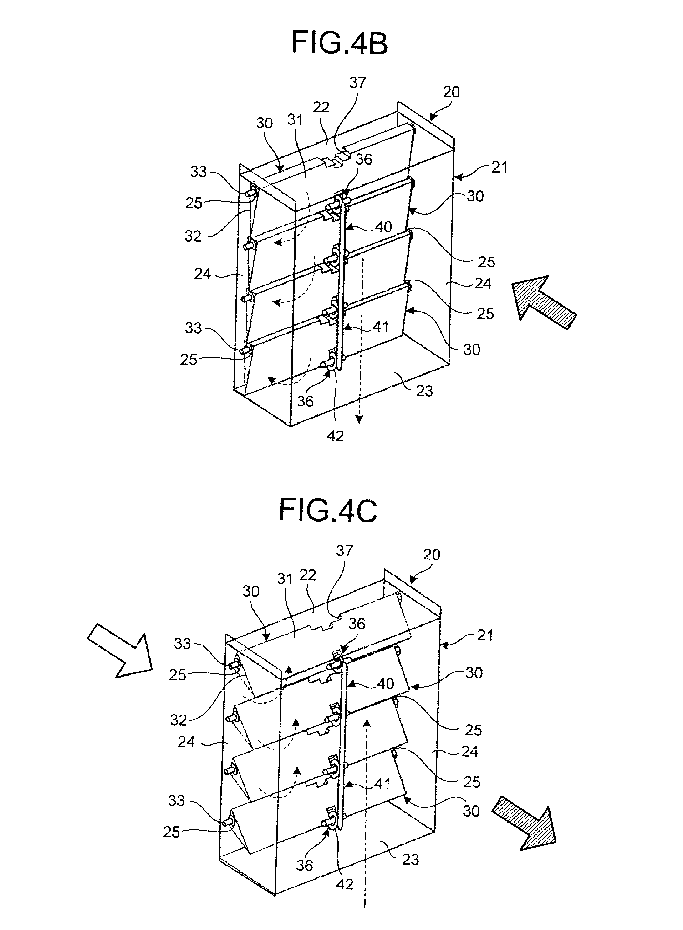

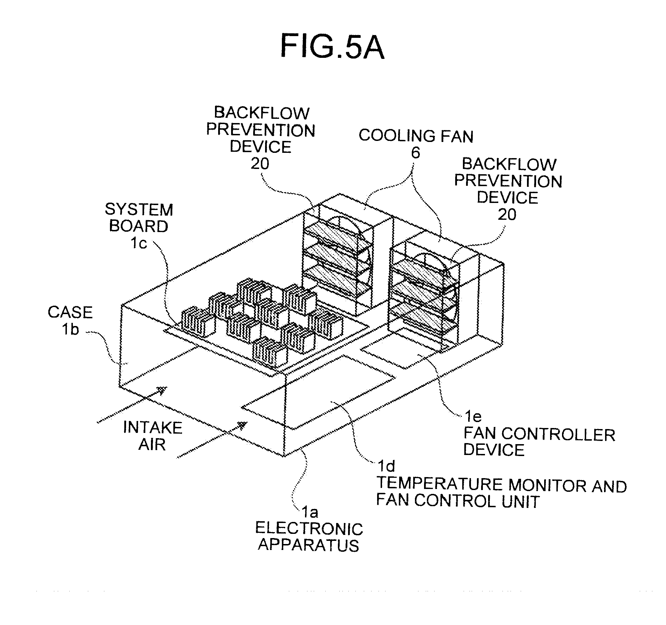

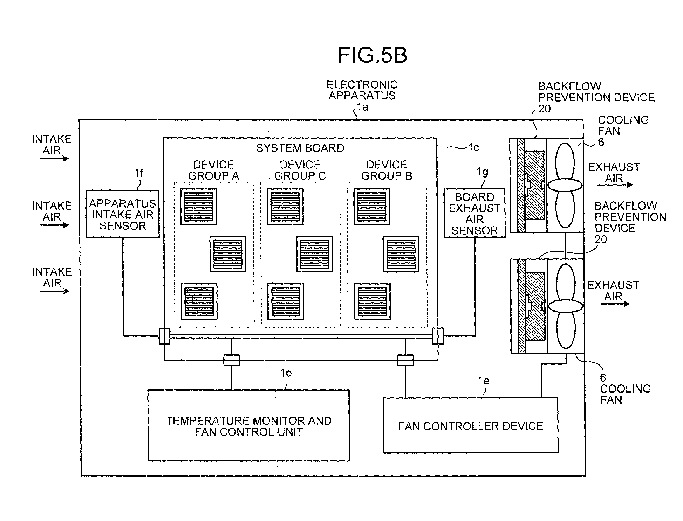

FiG. 3 is a perspective view illustrating the shape of a connecting member. FIGS. 4A, 4B, and 4C are perspective views illustrating flaps being opened, flaps being closed, and flaps being half opened, respectively. Furthermore, FIG. 5A is a perspective view illustrating the configuration of an electronic apparatus according to an example of the first embodiment. FIG. 5B is a block diagram illustrating the configuration of an electronic apparatus according to an example of the first embodiment. Note that in the backflow prevention device according to an example of the first embodiment, the same components as those of the aforementioned conventional backflow prevention device are designated with the same symbols and will not be repeatedly described. It should also be noted that the disclosed techniques are not limited by any of examples of the embodiments described below.

### Configuration of Backflow Prevention Device 20

As illustrated in FIG. 1, a backflow prevention device 20 includes a plurality of flaps 30 in a frame case 21. The flaps 30 are opened by airflow supplied from a cooling fan and closed by gravity when the airflow stops. The backflow prevention device 20 also includes a connecting member 40 for connecting between the flaps 30 so that these flaps 30 are cooperatively opened or closed. Here, a description will be made to a case where the cooling fan draws air to supply airflow; however, the fan may also blow rather than draw air.

That is, as illustrated in FIG. 1, the backflow prevention device 20 provided in a cooling apparatus includes the frame case 21 that has been formed in a vertically elongated rectangular shape as a whole. The frame case 21 has a top plate 22, a bottom plate 23, and a pair of side plates 24.

Inside the frame case 21 that forms the backflow prevention device 20, a plurality of (four in FIG. 1) flaps 30 for preventing backward airflow are disposed in parallel. Furthermore, as illustrated in the figure, the frame case 21 has rotational holes 25 formed therein to rotatably support rotational shafts 33 secured to the plurality of flaps 30.

As illustrated in FIGS. 1 and 2, the flap 30 has an elongated flat portion 31 as a whole. The flat portion 31 of the flap 30 is formed as a rectangular plate member that is made up of an upper side 31a, a lower side 31b, and two lateral sides 32. Furthermore, the lateral sides 32 of the flat portion 31 of the flap 30 have a pair of rotational shafts 33 secured thereto, protruding from the respective lateral sides 32. The pair of rotational shafts 33 rotatably fit into the rotational holes 25 formed in the frame case 21.

There is also formed a recessed notch 37 at about the center of the upper side 31a of the flap 30 (the left side in FIG. 2). The notch 37 formed in the flap 30 serves as the clearance with which a main body 41 of the connecting member 40 engages when the flap 30 is closed (see FIG. 4B).

Furthermore, at about the center of the lower side 31b of the flat portion 31 of the flap 30 (the right side in FIG. 2), there is also provided an engaging recessed portion 36 which has a recessed portion 35a and an engaging portion 35. As will be discussed later, the engaging recessed portion 36 provided in the flap 30 serves to engage with an engaging arm 42 of the connecting member 40.

As illustrated in FIG. 3, the connecting member 40 is made up of the elongated main body 41 with a plurality of engaging arms 42 that are formed generally in the shape of letter "C" at predetermined positions (four positions in FIG. 3) along the main body 41. Furthermore, at about the center of the engaging arm 42, there is formed a circular hole 43 to fit over the engaging recessed portion 36 of the flap 30.

That is, the connecting member 40 allows the engaging arms 42 of the connecting member 40 to connect between the engaging recessed portion 36 provided at the center of each flap 30 and the engaging recessed portion 36 provided at the center of an adjacent flap 30.

That is, the connecting member 40 connects between the plurality of flaps 30 so that the plurality of flaps 30 are cooperatively opened or closed. While connecting between the plurality of flaps 30 provided in the frame case 21, the connecting member 40 can also employ lift force resulting from a change in the amount and the pressure of airflow caused by a cooling apparatus to open the plurality of flaps 30 cooperatively at a predetermined angle. Furthermore, the connecting member 40 can cause the plurality of flaps 30 to cooperatively work so that the flaps 30 are simultaneously closed when airflow is allowed from outside.

As illustrated in FIG. 4A, for example, a large amount of airflow supplied by a cooling fan of the cooling apparatus causes the plurality of flaps 30 to be each opened up to as wide an angle as generally 90 degrees. Here, since the plurality of flaps 30 are connected at the center thereof to the connecting member 40, the flaps 30 are opened by airflow in the predetermined direction (as indicated by the broken-line arrows). Furthermore, at this time, since the connecting member 40 is also actuated upwardly (as indicated by the solid line arrow), the adjacent flaps 30 are opened generally at the same angle without any difference therebetween. This can prevent the flaps 30 from being opened or closed at irregular opening angles, and allow cooling air to be exhausted through air channel without vibrating the flaps 30.

Furthermore, as illustrated in FIG. 4B, when the surrounding air is drawn through the air channel of a failed cooling fan of the cooling apparatus, the airflow from outside Causes all the plurality of flaps 30 to close, thereby preventing an inflow of the surrounding air. In this case, since the plurality of flaps 30 are connected to each other by the connecting member 40, the connecting member 40 being actuated ensures that the plurality of flaps 30 are closed generally at the same timing. At this time, the engaging arm 42 of the connecting member 40 comes in between each engaging recessed portion 36 of the vertically adjacent flaps 30 when the plurality of flaps 30 are closed.

Furthermore, as illustrated in FIG. 4C, a medium amount of cooling airflow causes the plurality of flaps 30 to be opened in response to the medium amount of the airflow up to a predetermined angle position by the connecting member 40 being actuated. At this time, since the plurality of flaps 30 are connected to each other by the connecting member 40, the flaps 30 are each opened generally at the same angle (tilt angle). As such, the plurality of flaps 30 are opened to generally the same degree of opening (at the same tilt angle), and thus each of the flaps 30 can pass generally the same amount of air. This makes it possible to prevent the adjacent flaps 30 from vibrating and vibration noises caused by this vibration.

FIGS. 5A and 5B illustrate an electronic apparatus 1a. The electronic apparatus 1a includes, for example, in a rectangular parallelepiped case 1b, a system board 1c, a temperature monitor and fan control unit 1d, a fan controller device 1e, an apparatus intake air sensor 1f, a board exhaust air sensor 1g, and cooling fans 6. In addition, the electronic apparatus 1a includes the backflow prevention device 20 disposed between the cooling fans and the system board 1c. The system board 1c includes device groups A, B, and C mounted thereon which generate heat when activated.

The device groups A, B, and C can be a group of storage devices such as semiconductor devices or storage devices having storage media. The cooling fan 6 is, for example, an axial fan having an impeller wheel. Rotating the impeller wheel of the cooling fans 6 allows air to be drawn through an opening provided on the case 1b and pass over the system board 1c, thereby cooling the device groups.

Then, the cooling air having been used to cool the device groups is exhausted by the cooling fans 6 out of the case 1b via an exhaust outlet provided on the case 1b. The apparatus intake air sensor 1f senses the temperature of the cooling air that has been drawn. Furthermore, the board exhaust air sensor 1g senses the temperature of the cooling air that is exhausted.

The apparatus intake air sensor 1f and the board exhaust air sensor 1g are connected to the temperature monitor and fan control unit 1d via an interface such as I2C_I/F (Inter Integrated-Circuit Interface).

The temperature monitor and fan control unit 1d controls the fan controller device 1e based on the temperature of intake air and exhaust air. The fan controller device 1e is controlled by the temperature monitor and fan control unit 1d to provide control to the RPM of the cooling fans 6.

As described above, the backflow prevention device 20 and the electronic apparatus 1a according to an example of the first embodiment include the plurality of flaps 30 and the connecting member 40. The flaps 30 are rotatably supported in the respective rotational holes 25 formed in the frame case 21. The connecting member 40 connects between the plurality of flaps 30 to cooperatively open or close the plurality of flaps 30 in response to changes in the amount of airflow caused by the cooling apparatus. This makes it possible to prevent vibration noises caused by the flaps 30 vibrating and thereby fluttering and collision noises resulting from the flaps 30 abutting against the frame case 21.

### [b], Second Embodiment

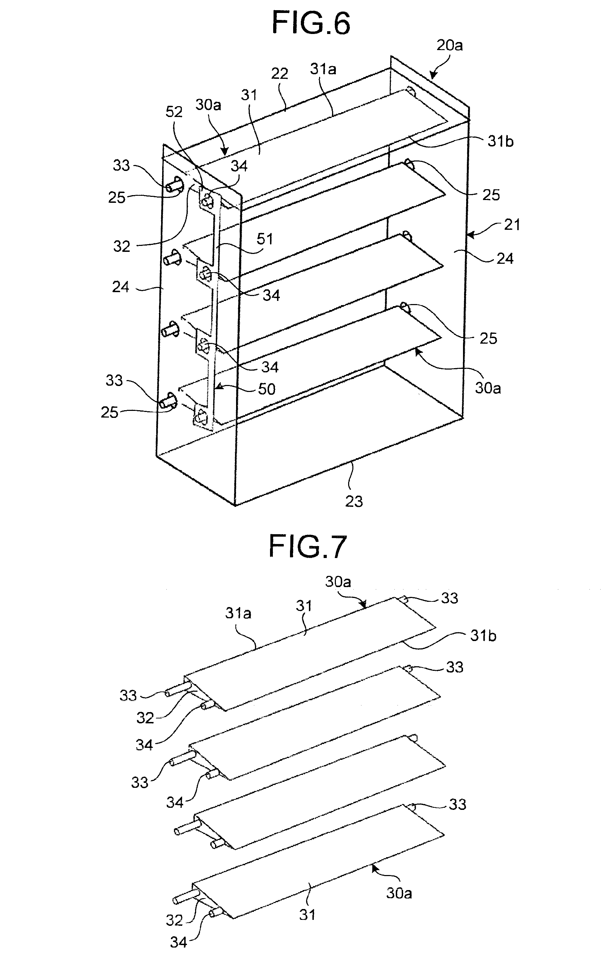

A description will be made to a backflow prevention device according to an example of a second embodiment. FIG. 6 is a view illustrating the inside of a backflow prevention device according to an example of the second embodiment. FIG. 7 is a perspective view illustrating the shape of flaps of a backflow prevention device.

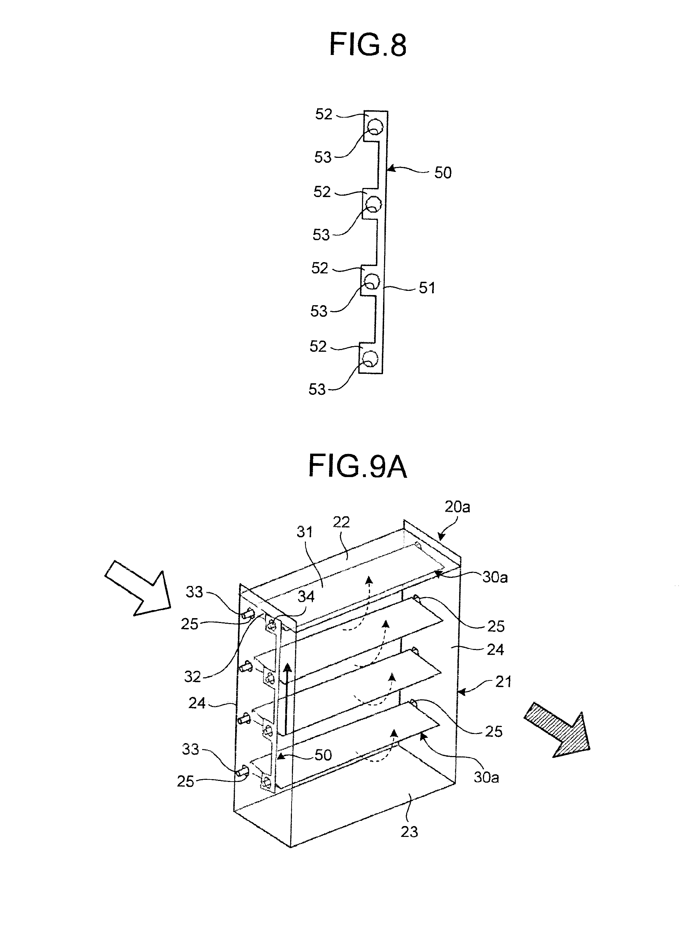

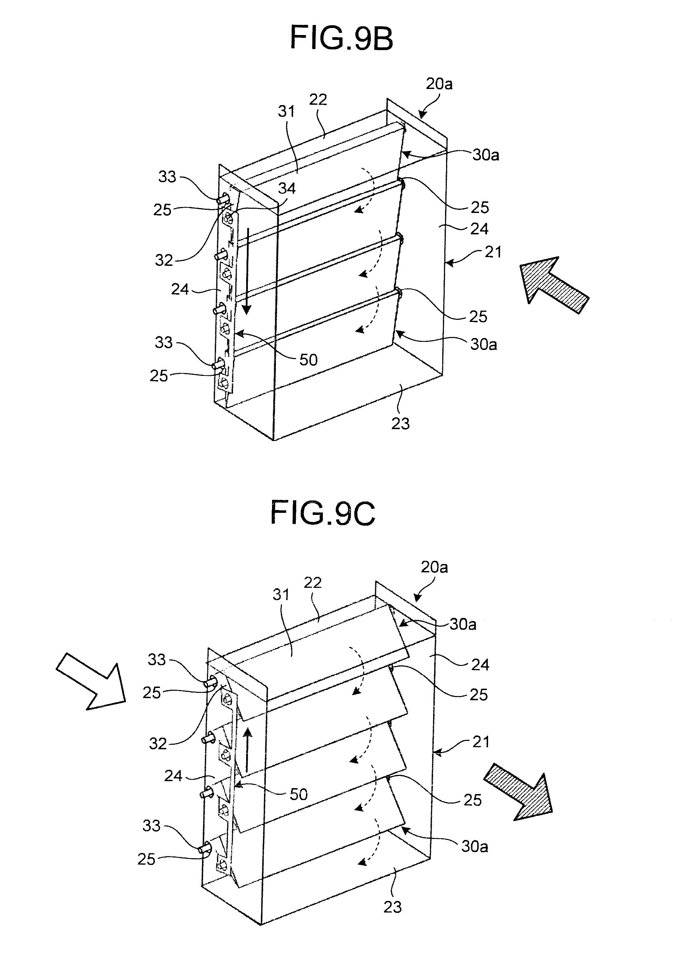

Furthermore, FIG. 8 is a perspective view illustrating the shape of a connecting member. FIGS. 9A, 9B, and 9C are perspective views illustrating flaps being opened, flaps being closed, and flaps being half opened, respectively. Note that in the backflow prevention device according to an example of the second embodiment, the same components as those of the aforementioned first embodiment are designated with the same symbols and will not be repeatedly described.

### Configuration of Backflow Prevention Device 20a

As illustrated in FIG. 6, a backflow prevention device 20a includes a plurality of flaps 30a in a frame case 21. The flaps 30a are opened by airflow supplied from a cooling fan and closed by gravity when the airflow stops. The backflow prevention device 20a also includes a connecting member 50 for connecting between rotational shafts 34 secured to the lateral sides 32 of the flaps 30a so that these flaps 30 are cooperatively opened or closed. Here, a description will be made to a case where the cooling fan draws air to supply airflow; however, the fan may also blow rather than draw air.

The backflow prevention device 20a allows rotational shafts 33 to freely open or close the plurality of flaps 30a and has rotational shafts 34 secured generally at the center of the lateral sides 32 of the flaps 30a in addition to the rotational shafts 33. Furthermore, the connecting member 50 for connecting between the flaps 30a using the rotational shafts 34 is rotatably supported by the rotational shafts 34.

That is, as illustrated in FIG. 7, the flaps 30a each have an elongated flat portion 31 as a whole. The flat portion 31 of the flap 30a is formed as a rectangular plate member that is made up of the upper side 31a, the lower side 31b, and the two lateral sides 32. Furthermore, the lateral sides 32 of the flat portion 31 of the flap 30a have the pair of rotational shafts 33 secured thereto, each protruding from the respective lateral sides 32. The pair of rotational shafts 33 of the flap 30a are fitted into the respective rotational holes 25 formed in the frame case 21.

Furthermore, as illustrated in FIG. 7, at about the center of one lateral side 32 of the flat portion 31 between the upper side 31a and the lower side 31b, there is a rotational shaft 34 secured to the lateral side 32, each protruding therefrom. The rotational shaft 34 is employed as a shaft portion for actuating the connecting member 50 in response to the amount and the pressure of airflow provided by a cooling fan.

As illustrated in FIG. 8, the connecting member 50 is made up of an elongated main body 51 with a plurality of protruding pieces 52 arranged at predetermined positions (four positions in FIG. 8) along the main body 51. Furthermore, at about the center of the protruding piece 52, there is formed a circular hole 53 to fit over the second rotational shaft 34 of the flap 30a. That is, the connecting member 50 connects between the center of the lateral side 32 of the flap 30a and the center of the lateral side 32 of an adjacent flap 30a. Furthermore, the protruding pieces 52 of the connecting member 50 come in between the rotational shafts 33 of the vertically adjacent flaps 30a when the plurality of flaps 30a are closed (FIG. 9B) .

Here, the connecting member 40 of the aforementioned first embodiment is provided at about the respective centers of the flat portions 31 of the flaps 30, and thus the connecting member 40 itself hinders airflow. However, the connecting member 50 according to the example of the second embodiment is disposed on the lateral sides 32 of the flaps 30a. This makes it possible to reduce airflow resistance to the flaps 30a.

That is, the rotational shafts 34 of the flaps 30a for rotatably supporting the connecting member 50 are provided at the respective centers of the lateral sides 32 of the flaps 30a. This arrangement can reduce the moment induced when the flaps 30a are opened or closed, allowing even a small amount of airflow to actuate the connecting member 50 and thereby open the flaps 30a. Furthermore, even when a cooling fan supplies only slow airflow, a reduced airflow resistance allows the flaps 30a to be opened up to a predetermined angle by the connecting member 50 being actuated. This can further reduce resistance to airflow.

Here, the rotational shafts 33 of the flaps 30a for rotatably supporting the connecting member 50 are to be provided at about the respective centers of the lateral sides 32 of the flaps 30a. However, the rotational shafts 34 may be located not only at the respective centers but also towards the rotational shafts 33 or near the rotational shafts 33. Furthermore, the connecting member 50 may also be provided at either side of the flaps 30a.

As illustrated in FIG. 9A, for example, a large amount of airflow supplied by a cooling fan of a cooling apparatus can open each of the plurality of flaps 30a up to as wide an angle as generally 90 degrees. Here, the rotational shafts 34 secured to the respective centers of the lateral sides 32 of the plurality of flaps 30a are connected to each other by the connecting member 50. Thus, the flaps 30a are opened by airflow in the predetermined direction (as indicated by the broken-line arrows). Furthermore, since the connecting member 50 is also actuated upwardly (as indicated by the solid line arrow) at this time, the adjacent flaps 30a are opened generally at the same angle without any difference therebetween.

Furthermore, as illustrated in FIG. 9B, the surrounding air may be drawn through the air channel of a failed cooling fan of the cooling apparatus. In this case, the airflow from outside causes all the plurality of flaps 30a to be closed, thereby preventing an inflow of the surrounding air. In this case, since the plurality of flaps 30 are connected to each other by the connecting member 50, the connecting member 50 being actuated ensures that the plurality of flaps 30a are closed generally at the same timing. At this time, the protruding pieces 52 of the connecting member 50 come in between the rotational shafts 33 of the vertically adjacent flaps 30a when the plurality of flaps 30a are closed.

Furthermore, as illustrated in FIG. 9C, a medium amount of cooling airflow causes the plurality of flaps 30a to be opened in response to the medium amount of the airflow up to a predetermined angle position by the connecting member 50 being actuated. At this time, since the plurality of flaps 30 are connected to each other by the connecting member 50, the flaps 30a are opened generally at the same opening angle (tilt angle). As such, the plurality of flaps 30a are opened generally to the same degree of opening (at the same tilt angle), and thus each of the flaps 30a can pass generally the same amount of air.

As described above, the backflow prevention device 20a according to the example of the second embodiment allows the rotational shafts 33 to freely open or close the plurality of flaps 30a. The backflow prevention device 20a has the rotational shafts 34 secured generally at the respective centers of the lateral sides 32 in addition to the rotational shafts 33. Furthermore, the backflow prevention device 20a also includes the connecting member 50 for connecting between the flaps 30a with the rotational shafts 34. Accordingly, the connecting member 50 being actuated can provide generally the same tilt angle and degree of opening (opening area) to the flaps 30a. As such, the flaps 30a can each pass the same amount of air.

Furthermore, the connecting member 50 cooperatively opens or closes the plurality of flaps 30a in response to changes in the amount of airflow caused by a cooling apparatus. It is thus possible to prevent collision noises caused by fluttering flaps 30a or flaps 30a abutting against or colliding with each other.

Note that as with the first embodiment, the backflow prevention device 20a according to the example of the second embodiment can be incorporated into the electronic apparatus 1a for use.

### [c] Third Embodiment

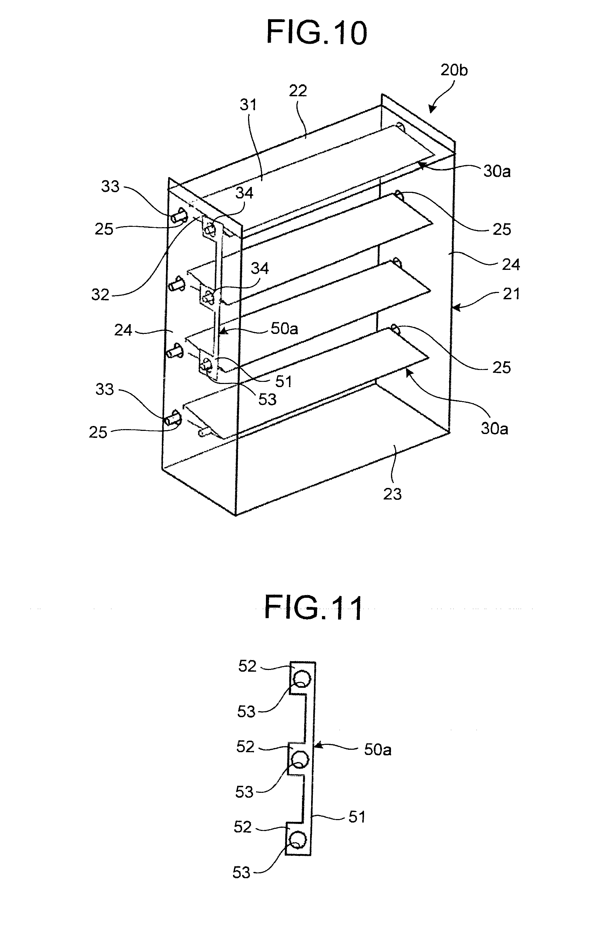

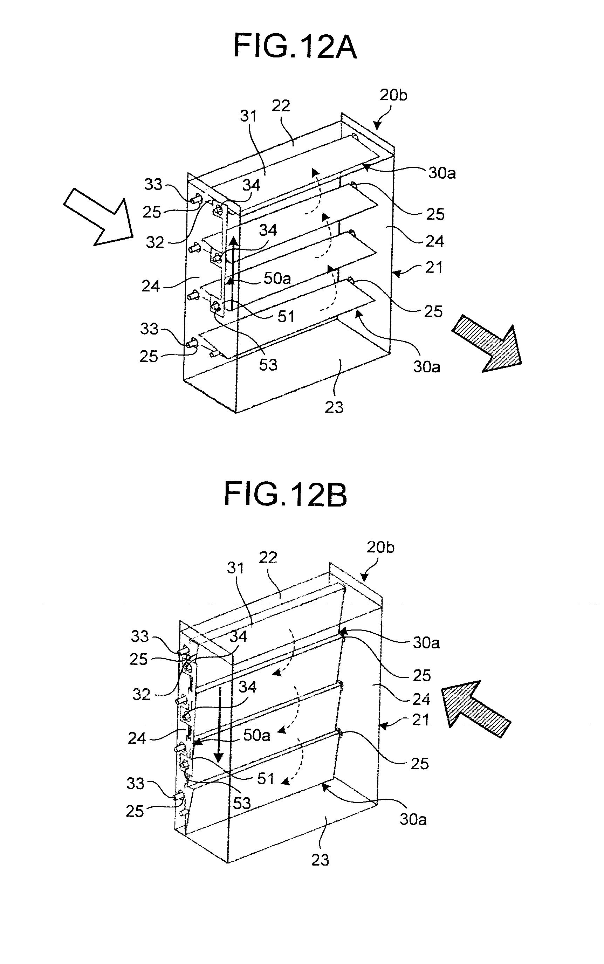

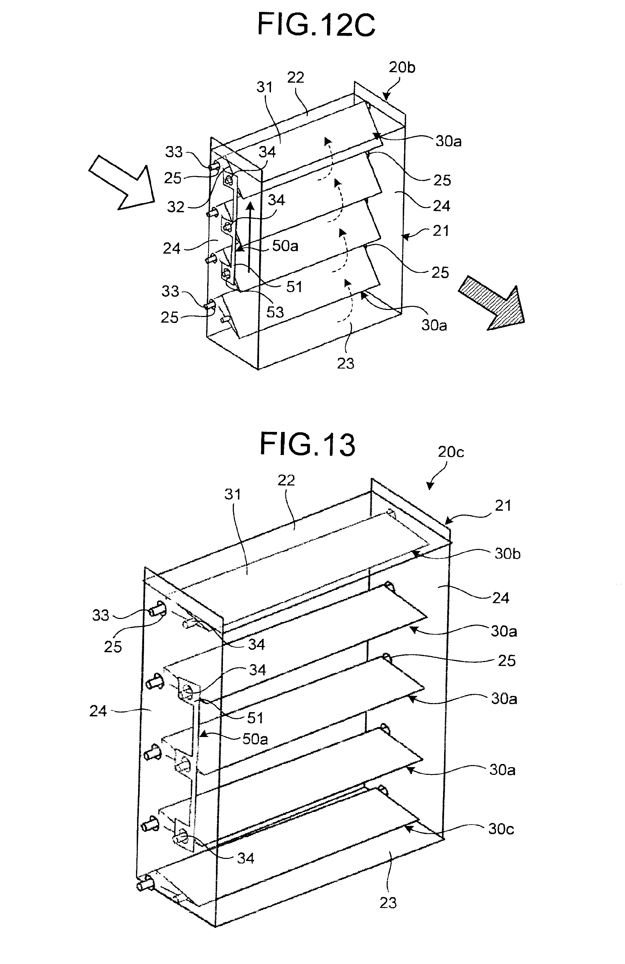

A description will be made to a backflow prevention device according to an example of a third embodiment. FIG. 10 is a view illustrating the inside of a backflow prevention device according to the third embodiment. FIG. 11 is a perspective view illustrating the shape of a connecting member. FIGS. 12A, 12B, and 12C are perspective views illustrating flaps being opened, flaps being closed, and flaps being half opened, respectively.

Note that in the backflow prevention device according to the example of the third embodiment to be described below, the same components of the backflow prevention device as those of the backflow prevention device according to the example of the aforementioned second embodiment are designated with the same symbols and will not be repeatedly described.

### Configuration of Backflow Prevention Device 20b

As illustrated in FIG. 10, a backflow prevention device 20b includes a plurality of flaps 30a arranged in parallel in a frame case 21, and a connecting member 50a for connecting between the plurality of flaps 30a except at least one of the flaps 30a. The connecting member 50a connecting between the flaps 30a can cooperatively open or close the plurality of flaps 30a.

As illustrated in FIG. 10, the backflow prevention device 20b includes the frame case 21 that is vertically elongated and rectangular in shape as a whole. The frame case 21 has a top plate 22, a bottom plate 23, and a pair of side plates 24. The frame case 21 that forms the backflow prevention device 20b includes the plurality of flaps 30a for preventing backward airflow.

The flat portion 31 of the flap 30a has an upper side 31a, a lower side 31b, and two lateral sides 32, with a pair of rotational shafts 33 and a rotational shaft 34 secured to the lateral sides 32. The rotational shafts 33 are fitted into the respective rotational holes 25 formed in the frame case 21. Furthermore, the rotational shaft 34 is provided as a shaft portion for actuating the connecting member 50a in response to the amount and the pressure of airflow supplied by a cooling fan.

The connecting member 50a is made up of the elongated main body 51 with a plurality of protruding pieces 52 arranged at predetermined positions (three positions in FIG. 11) along the main body 51. Furthermore, at about the center of the protruding piece 52, there is formed a circular hole 53 to fit over the rotational shaft 34 of the flap 30a. The connecting member 50a supportively connects between the lateral sides 32 of the plurality of flaps 30a.

As illustrated in FIG. 10, the lowest one of the plurality of flaps 30a provided in the frame case 21 is not connected to the connecting member 50a, while the three flaps 30a from the top are connected to the connecting member 50a. Here, since the three flaps 30a from the top are connected therebetween by the connecting member 50a, the connecting member 50a can cooperatively open or close the plurality of flaps 30a in response to changes in the amount of airflow caused by the cooling apparatus.

Furthermore, the plurality of flaps 30a connected therebetween by the connecting member 50a (or the third flap from the top) will never come into contact with the flap 30a located under that flap.

As illustrated in FIG. 12A, for example, a large amount of airflow supplied by a cooling fan of a cooling apparatus causes the plurality of flaps 30a connected therebetween by the connecting member 50a to be opened up to as wide an angle as generally 90 degrees in the predetermined direction (as indicated by the broken-line arrows). Furthermore, since the connecting member 50a is also actuated upwardly (as indicated by the solid line arrow) at this time, the adjacent flaps 30a are opened generally at the same angle without any difference therebetween. The flap 30a not connected to the connecting member 50a is also opened at a wide angle.

Furthermore, as illustrated in FIG. 12B, the surrounding air may be drawn through the air channel of a failed cooling fan of a cooling apparatus. In this case, since the plurality of flaps 30a are connected to each other by the connecting member 50a, the connecting member 50a being actuated ensures that the plurality of flaps 30a are closed generally at the same timing.

Furthermore, as illustrated in FIG. 12C, a medium amount of cooling airflow causes the plurality of flaps 30a to be opened by lift force in response to the medium amount of the airflow up to a predetermined angle position by the connecting member 50a being actuated. At this time, since the plurality of flaps 30a are connected to each other by the connecting member 50a, the flaps 30a are each opened generally at the same angle (tilt angle). As such, the plurality of flaps 30a are opened generally to the same degree of opening (at the same tilt angle), and thus each of the flaps 30 can pass generally the same amount of air.

As described above, the backflow prevention device 20b according to the example of the third embodiment includes the plurality of flaps 30a arranged in parallel in the frame case 21, and the connecting member 50a for connecting between the plurality of flaps 30a except at least one of the flaps 30a. The flap 30a not connected to the connecting member 50a can be reduced in weight, so that the not-connected flap 30a is opened at a greater angle with the same amount of airflow than the flaps 30a connected to each other. It is thus possible to reduce fluttering (vibrations) due to cooling airflow, thereby ensuring stability.

Furthermore, the lowest one of the plurality of flaps 30a is reduced in weight by the amount resulting from that flap being not connected to the connecting member 50a. Accordingly, the not-connected flap 30a is opened at a greater angle than the three flaps 30a connected to each other by the connecting member 50a, with air-driven vibrations reduced and with stability.

Note that as with the first embodiment, the backflow prevention device 20b according to the example of the third embodiment can be incorporated into the electronic apparatus 1a for use.

### [d] Fourth Embodiment

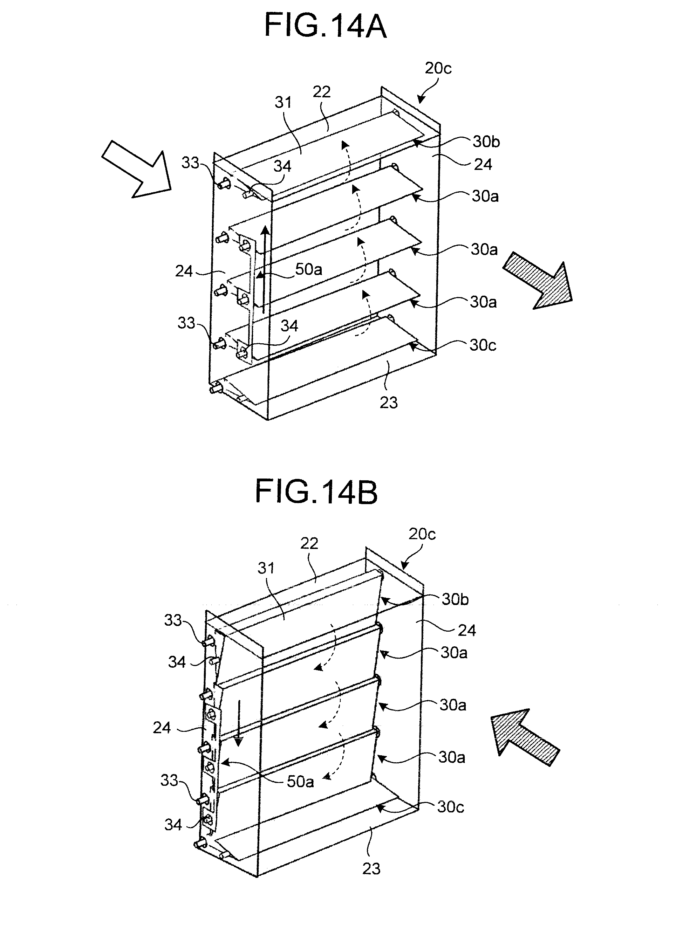

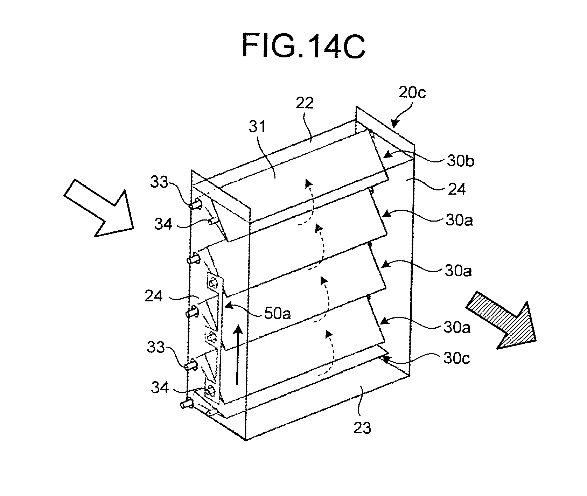

A backflow prevention device according to a fourth embodiment will be described in detail. FIG. 13 is a view illustrating the inside of the backflow prevention device according to the fourth embodiment. FIGS. 14A, 14B, and 14C are perspective views illustrating flaps being opened, flaps being closed, and flaps being half opened, respectively.

Note that in the backflow prevention device according to the example of the fourth embodiment to be described below, the same components of the backflow prevention device as those of the backflow prevention device according to the example of the aforementioned third embodiment are designated with the same symbols and will not be repeatedly described.

### Configuration of Backflow Prevention Device 20c

As illustrated in FIG. 13, a backflow prevention device 20c includes a frame case 21 which is vertically elongated and rectangular in shape as a whole. The frame case 21 has a top plate 22, a bottom plate 23, and a pair of side plates 24. Furthermore, the frame case 21 that forms the backflow prevention device 20c includes a plurality of flaps 30a, 30b, and 30c for preventing backward airflow.

The flat portion 31 of the flap 30 has an upper side 31a, a lower side 31b, and two lateral sides 32, with a pair of rotational shafts 33 and a pair of rotational shafts 34 secured to the lateral sides 32. The rotational shafts 33 are fitted into the rotational holes 25 formed in the frame case 21. Furthermore, the rotational shaft 34 is provided as a shaft portion for actuating the connecting member 50a in response to the amount and the pressure of airflow supplied by a cooling fan. The flaps 30a of the plurality of flaps 30a, 30b, and 30c are connected to each other by the connecting member 50a.

As illustrated in FIG. 13, the lowest flap 30c of the plurality of flaps 30 provided in the frame case 21 is not connected to the connecting member 50a, while the three flaps 30a disposed between the flaps 30b and 30c are connected to each other by the connecting member 50a. Here, since the intermediate three flaps 30a are connected therebetween by the connecting member 50a, the connecting member 50a can cooperatively open or close the plurality of flaps 30 by lift force in response to changes in the amount of airflow caused by a cooling apparatus.

That is, the frame case 21 that forms the backflow prevention device 20c includes the three flaps 30a for preventing backward airflow, the flap 30b, and the flap 30c. Of these flaps, as illustrated in FIG. 13, the top flap 30b is located near the top plate 22 of the frame case 21. Furthermore, the lowest flap 30c is provided in contact with the bottom plate 23 of the frame case 21.

For example, when the frame case 21 of the backflow prevention device 20c illustrated in FIG. 13 is inverted, the top plate 22 of FIG. 13 is now the bottom plate and the bottom plate 23 of FIG. 13 is now the top plate. In this case, since the flap 30c illustrated in FIG. 13 is located near the top plate 22, the flap 30c serves as an active flap. On the other hand, since the flap 30b illustrated in FIG. 13 is brought into contact with the bottom plate 23, the flaps 30b will not function as an active flap.

The connecting member 50a is made up of an elongated main body 51 with a plurality of protruding pieces 52 arranged at predetermined positions (three positions in FIG. 13) along the main body 51. Furthermore, at about the center of the protruding piece 52, there is formed a circular hole 53 to fit over the second rotational shaft 34 of the flap 30a. The connecting member 50a supportively connects between the lateral sides 32 of the plurality of flaps 30a.

That is, the connecting member 50a connects between the plurality of flaps 30a so that the plurality of flaps 30a are cooperatively opened or closed. The connecting member 50a can not only connect between the plurality of flaps 30a provided in the frame case 21 but also open the plurality of flaps 30a cooperatively at a predetermined angle in response to changes in the amount of airflow caused by a cooling fan. Furthermore, when the surrounding air flows in from outside, the connecting member 50a can cause the plurality of flaps 30a to cooperatively work so that the plurality of flaps 30a are simultaneously closed.

As illustrated in FIG. 14A, for example, a large amount of airflow may be supplied by a cooling fan of a cooling apparatus while the three flaps 30a of the plurality of flaps 30a, 30b, and 30c are connected to each other by the connecting member 50a. In this case, while being connected to each other, the flaps 30a are opened in the predetermined direction (as indicated by the broken-line arrows) up to as wide an angle as generally 90 degrees. Furthermore, at this time, since the connecting member 50a is also actuated upwardly (as indicated by the solid line arrow), the adjacent flaps 30a are opened generally at the same angle without any difference therebetween. The flap 30b that is not connected to the connecting member 50a is also opened at a wide angle.

Furthermore, as illustrated in FIG. 14B, the surrounding air may be drawn through the air channel of a failed cooling fan of a cooling apparatus while the plurality of flaps 30a are connected to each other by the connecting member 50a. In this case, the connecting member 50a being actuated ensures that the plurality of flaps 30a are closed generally at the same timing. Furthermore, at this time, the flap 30b that is not connected to the connecting member 50a is also closed generally at the same timing.

Furthermore, as illustrated in FIG. 14C, a medium amount of cooling airflow causes the plurality of flaps 30a to be opened up to a predetermined angle position by the connecting member 50a being actuated in response to the medium amount of the airflow. At this time, since the plurality of flaps 30a are connected to each other by the connecting member 50a, the flaps 30a are each opened generally at the same angle (tilt angle). Furthermore, at this time, the flap 30b that is not connected to the connecting member 50a is also opened generally at the same angle, allowing the flap 30b to pass generally the same amount of air as that by the other flaps 30a.

As described above, the backflow prevention device 20c according to the fourth embodiment is configured such that the connecting member 50a connects between the flaps 30a except the flaps 30b and 30c which are disposed at the top and bottom of the frame case 21, respectively. Even when the frame case 21 is inverted vertically, this arrangement allows the backflow prevention device 20c to serve as a backflow prevention device, and thus provides improved applicability. It is thus possible to avoid the malfunctioning of the apparatus which may result from the backflow prevention device being inverted when incorporated therein.

Furthermore, like the aforementioned first to third embodiments, the connecting member 50a can cooperatively open or close the plurality of flaps 30a in response to changes in the amount of airflow caused by a cooling apparatus. This makes it possible to reduce the weight of the flaps 30a and prevent vibrations due to fluttering of the flaps 30a, contact noises made between the flaps 30a, and collision noises caused by the flaps 30a colliding with the frame.

### [e] Fifth Embodiment

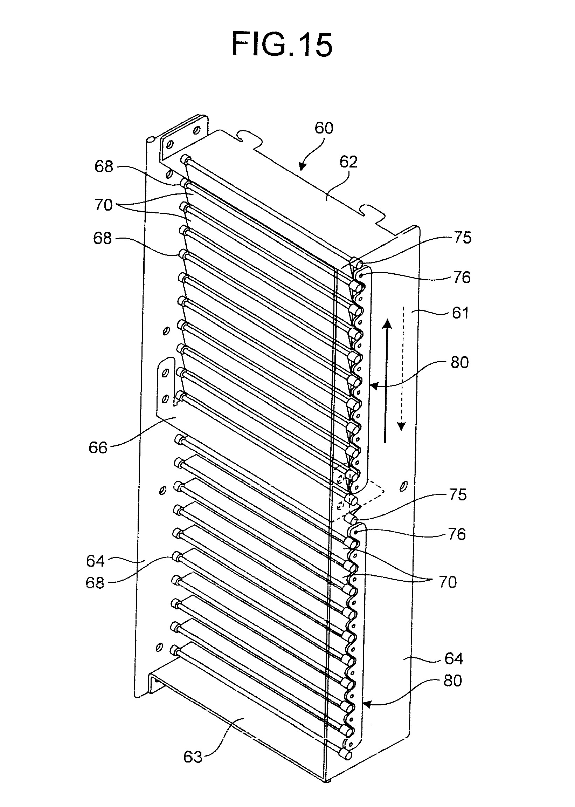

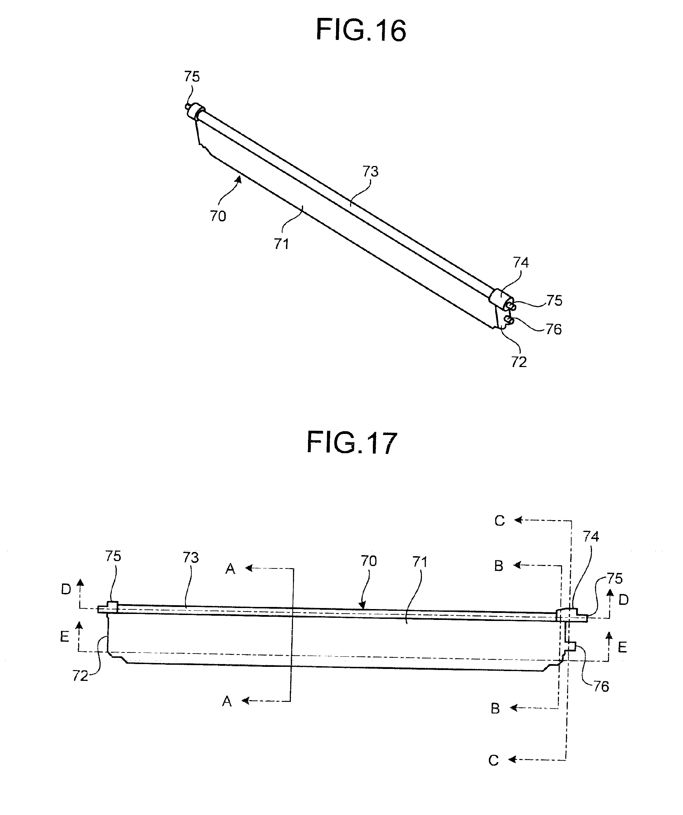

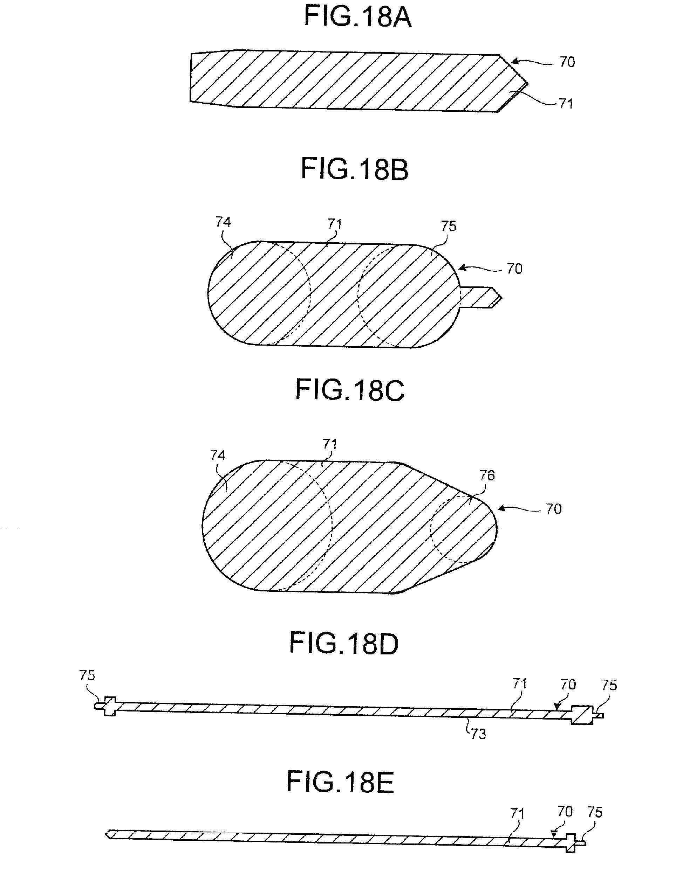

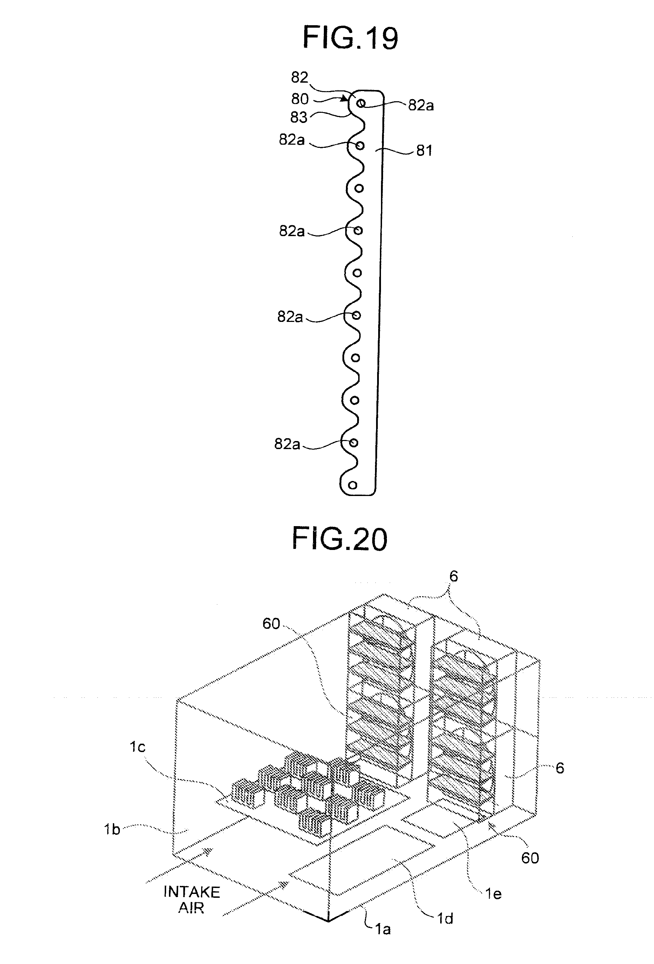

A description will be made to a backflow prevention device according to an example of a fifth embodiment. FIG. 15 is a view illustrating the inside of the backflow prevention device according to the fifth embodiment. FIG. 16 is a perspective view illustrating a flap. FIG. 17 is a plan view illustrating a flap. FIG. 18A is a cross sectional view taken along A-A of FIG. 17, FIG. 18B is a cross sectional view taken along B-B of FIG. 17, FIG. 18C is a cross sectional view taken along C-C of FIG. 17, FIG. 18D is a cross sectional view taken along D-D of FIG. 17, and FIG. 18E is a cross sectional view taken along E-E of FIG. 17. FIG. 19 is a plan view illustrating the shape of a connecting member.

### Configuration of Backflow Prevention Device 60

As illustrated in FIG. 15, a backflow prevention device 60 includes a frame case 61 in which included are a plurality of flaps 70 that are opened by airflow supplied from a cooling fan and closed by gravity when the airflow stops. The backflow prevention device 60 also includes a connecting member 80 that connects the plurality of flaps 70 so that the flaps 70 are cooperatively opened or closed. Here, a description will be made to a case where the cooling fan draws air to supply airflow; however, the fan may also blow rather than draw air.

That is, as illustrated in FIG. 15, the backflow prevention device 60 includes the frame case 61 that is vertically elongated and rectangular in shape as a whole. The frame case 61 has a top plate 62, a bottom plate 63, and a pair of side plates 64. Furthermore, the inside of the frame case 61 that constitutes the backflow prevention device 60 is divided by a partition plate 66, so that the upper stage and the lower stage of the partition plate 66 are each provided with a plurality of flaps 70 (ten flaps disposed vertically in FIG. 15) for preventing backward airflow.

The backflow prevention device 60 allows rotational shafts 75 to freely open or close the plurality of flaps 70 and has a rotational shaft 76 secured generally at the center of a lateral side 72 of the flap 70. On the other hand, the connecting member 80 that allows the rotational shafts 76 to connect between the flaps 70 is rotatably supported by the rotational shafts 76 secured to the respective lateral sides 72 of the flaps 70. The pair of rotational shafts 75 of the flap 70 are fitted into respective rotation holes 68 formed in the frame case 61.

As illustrated in FIGS. 16 to 17 and FIGS. 18A to 18E, the flap 70 has a flat portion 71 that is elongated as a whole, and is formed as a plate member with an upper side 73 and the lateral sides 72. Furthermore, the rotational shafts 76 is also secured at about the center of the lateral side 72 of the flat portion 71 of the flap 70, protruding from the lateral side 72.

The connecting member 80 is made up of an elongated main body 81 with a plurality of curved protruding pieces 82 arranged at predetermined positions (ten positions in FIG. 19) along the main body 81. Furthermore, at about the center of the protruding piece 82, there is formed a circular hole 82a for fitting over the rotational shaft 76 of the flap 70.

That is, the connecting member 80 is capable of connecting between the plurality of flaps 70 and cooperatively opening the plurality of flaps 70 by lift force at a predetermined angle in response to changes in the amount of airflow caused by a cooling apparatus. Furthermore, likewise, the connecting member 80 can cooperatively work the plurality of flaps 70 so that the plurality of flaps 70 are closed simultaneously. A recessed portion 83 that continues between the protruding pieces 82 of the connecting member 80 comes in between the rotational shafts 76 (FIG. 15) of the vertically adjacent flaps 70 when the plurality of flaps 70 are closed.

FIG. 20 is a view illustrating the configuration of the electronic apparatus 1a that incorporates the backflow prevention device 60. As illustrated in FIG. 20, the backflow prevention device 60 having a vertically elongated frame case is capable of preventing backflow through airflow channels of the cooling fans 6 that are stacked vertically in two stages.

As described above, the backflow prevention device 60 according to the fifth embodiment includes the plurality of flaps 70 that are rotatably supported in the plurality of rotation holes 68 formed inside the frame case 61. The backflow prevention device 60 also includes the connecting member 80 that connects between the plurality of flaps 70 and cooperatively opens or closes the plurality of flaps 70 in response to changes in the amount of airflow caused by a cooling apparatus. This arrangement allows for preventing vibrations due to fluttering of the flaps 70, contact noises made between the flaps 70, and collision noises caused by the flaps 70 colliding with the frame case 61.

### Fabricated Structure of Backflow Prevention Device 1

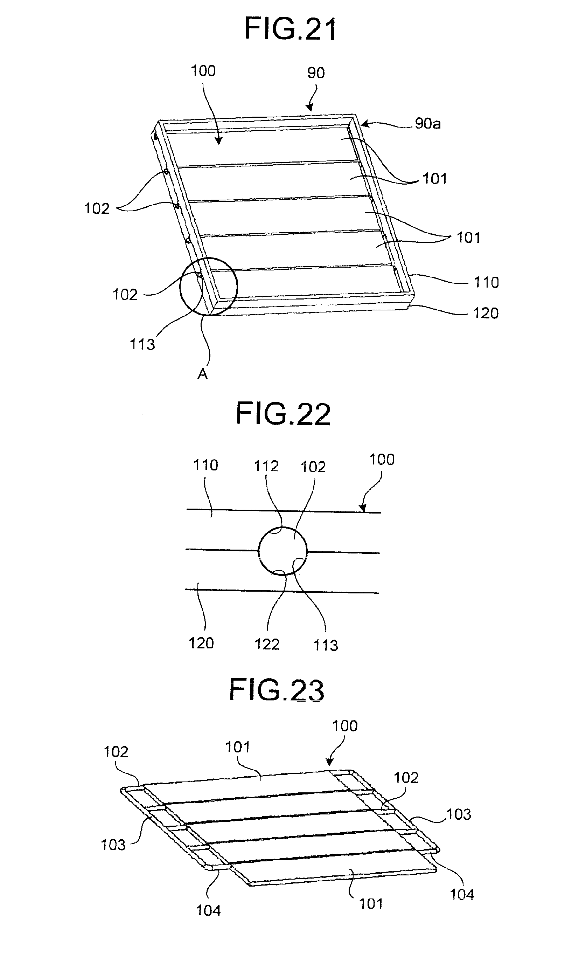

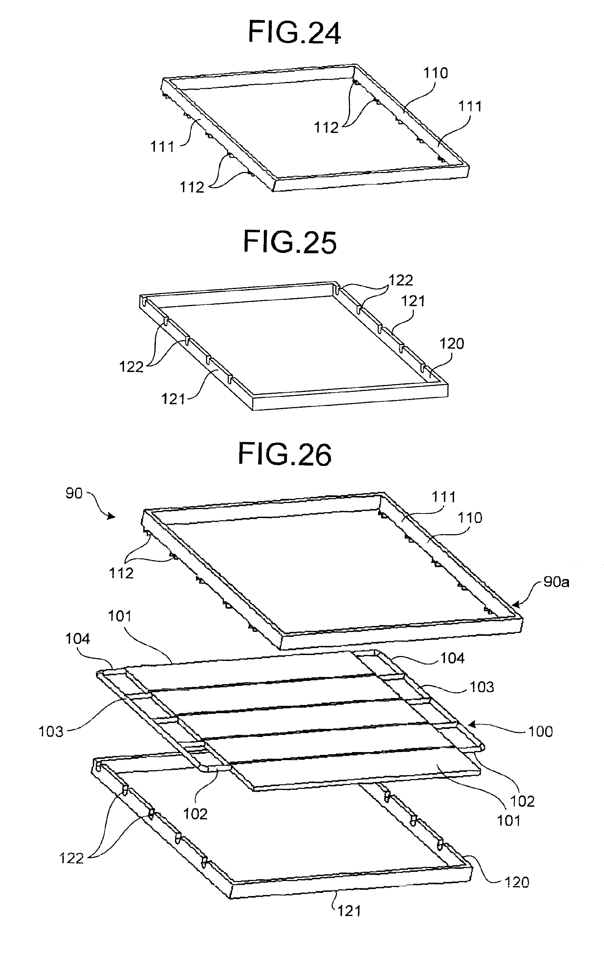

Now, referring to FIGS. 21 to 28, the fabricated structure of a backflow prevention device will be described. FIG. 21 is a perspective view illustrating the outer appearance of a backflow prevention device. FIG. 22 is an enlarged view of the portion A of FIG. 21. FIG. 23 is a perspective view illustrating a flap assembly. FIG. 24 is a perspective view illustrating a first frame case.

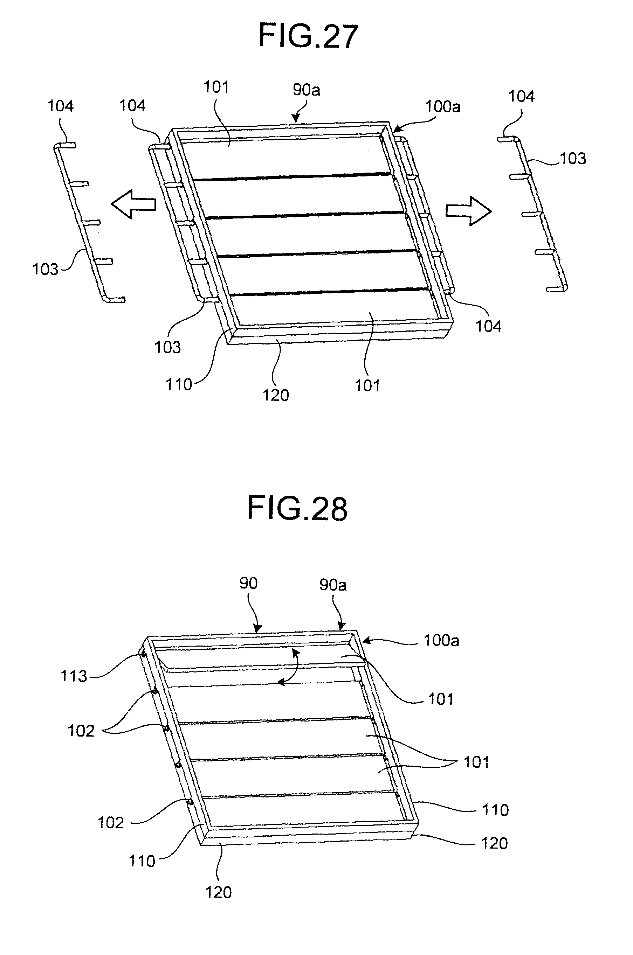

Furthermore, FIG. 25 is a perspective view illustrating a second frame case. FIG. 26 is an exploded perspective view illustrating the fabricated structure of a backflow prevention device. Furthermore, FIG. 27 is a perspective view illustrating a method for fabricating a backflow prevention device. FIG. 28 is a perspective view illustrating the fabricated structure of a backflow prevention device.

As illustrated in FIG. 21, a backflow prevention device 90 is composed of a frame case 90a of the backflow prevention device 90 that is made up of a first frame case 110 and a second frame case 120, and a flap assembly 100 disposed between the first and second frame cases 110 and 120.

The backflow prevention device 90 includes the flap assembly 100 into which a plurality of (five in FIG. 21) flaps 101 are integrally molded. Then, the flap assembly 100 thus molded in one piece is sandwiched between the upper and lower frame cases, i.e., the first frame case 110 and the second frame case 120, which have been separately molded.

That is, while being arranged separately in parallel to each other, the plurality of flaps 101 are integrated into the flap assembly 100 which has a connection frame 103 (FIG. 23) for connecting between one ends of rotational shafts 102 of the flaps 101. The frame case 90a has a pair of the first frame case 110 and the second frame case 120 which are formed in the same size. The first frame case 110 and the second frame case 120 that constitute the frame case 90a are provided with semicircular holes 112 and semicircular holes 122 (FIG. 22) for rotatably supporting the rotational shafts 102 of the plurality of flaps 101.

More specifically, the flap assembly 100 (FIG. 23) is a one-piece assembly into which separately arranged flaps 101 have been integrally molded. The flap assembly 100 is also integrally molded, on its both sides, with the connection frame 103 (FIG. 23) while connecting between the rotational shafts 102 secured to the flaps 101. That is, the plurality of flaps 101 are integrated into the flap assembly 100 so that the plurality of flaps 101 are arranged in parallel to each other, and the rotational shafts 102 provided on the plurality of flaps 101 are connected to the connection frame 103 (FIG. 23).

The rotational shafts 102 of the plurality of flaps 101 are integrally molded into the connection frame103 for connecting between the rotational shafts 102 of the adjacent flaps 101. Here, part of a connecting portion 104 of the connection frame 103 serves as the rotational shaft 102 of the flap 101.

On the other hand, the first frame case 110 (FIG. 24) is formed as a square frame case that has a width enough to accommodate the number of flaps 101 employed. Furthermore, one side of a side plate portion 111 of the first frame case 110 (the lower side in FIG. 24) is provided with the semicircular holes 112 to fit over one side of the rotational shafts 102 of the flaps 101 (the upper side in FIG. 22).

Likewise, the second frame case 120 (FIG. 25) is formed as a square frame case that has a width enough to accommodate the number of flaps 101 employed. Furthermore, one side of a side plate portion 121 of the second frame case 120 (the upper side in FIG. 25) is provided with the semicircular holes 122 to fit over one sides of the rotational shafts 102 of the flaps 101 (the lower side in FIG. 22).

That is, as illustrated in FIG. 26, the first frame case 110 and the second frame case 120 are combined together into the frame case 90a. At this time, the semicircular holes 112 of the first frame case 110 and the semicircular holes 122 of the second frame case 120 can also be joined together into rotation holes 113 to fit over the rotational shafts 102 of the flaps 101. Here, the flaps 101 that constitute the flap assembly 100 are formed of a resin-based material such as an ABS (Acrylonitrile Butadiene Styrene) material.

Furthermore, as illustrated in FIGS. 26 and 27, to fabricate the backflow prevention device 90, the flap assembly 100 is mounted in between the first frame case 110 and the second frame case 120 which form the frame case 90a. Then, the rotational shafts 102 of the flap assembly 100 are fitted into the respective semicircular holes 112 of the first frame case 110 and the semicircular holes 122 of the second frame case 120.

Next, the rotational shafts 102 of the flaps 101, the connection frame 103, and the connecting portion 104 are separated. More specifically, the connecting portion 104 for joining together the rotational shafts 102 of the flaps 101 and the connection frame 103 is cut, thereby removing the flap assembly 100 from the connection frame 103.

As illustrated in FIG. 28, it is thus possible to fabricate the backflow prevention device 90 in which the plurality of flaps 101 open and close about the rotational shafts 102 that are rotatably supported in the rotation holes 113 of the frame case 90a. That is, since the plurality of flaps 101 are divided into individual flaps 101, the flaps 101 are capable of opening and closing about the rotational shafts 102.

As described above, according to the fabricated structure of the backflow prevention device 90, the plurality of flaps 101 are separately arranged in parallel to each other, and integrally molded into the flap assembly 100 that has the connection frame 103 for connecting between one ends of the rotational shafts 102 of the plurality of flaps 101. Furthermore, the connecting portion 104 of the connection frame 103 has only to be cut to incorporate the flaps 101 into the frame case 90a. This eliminates the necessity of distinguishing between the front and rear side of the flaps 101 upon assembly of the flaps into the frame case. It is also possible to reduce mistakes in assembling the flaps 101 or an increase in the number of steps resulting from an increase in the number of flaps 101 to be employed.

### Fabricated Structure of Backflow Prevention Device 2

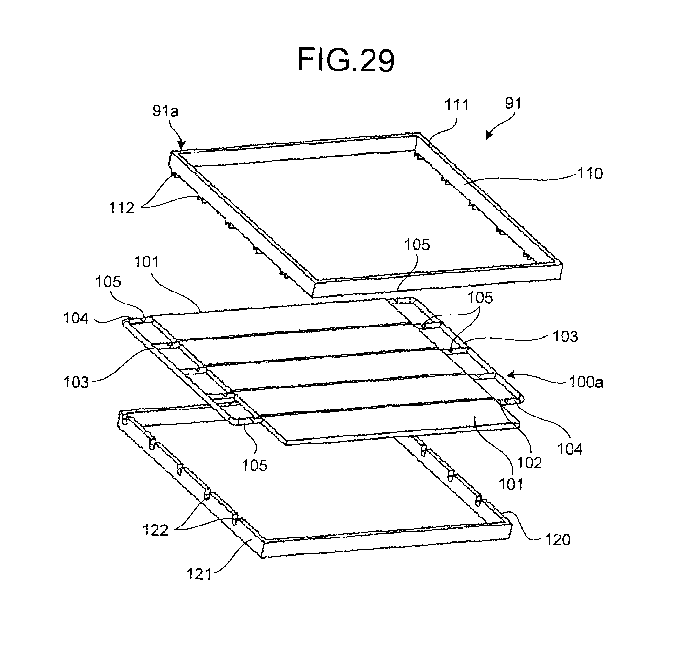

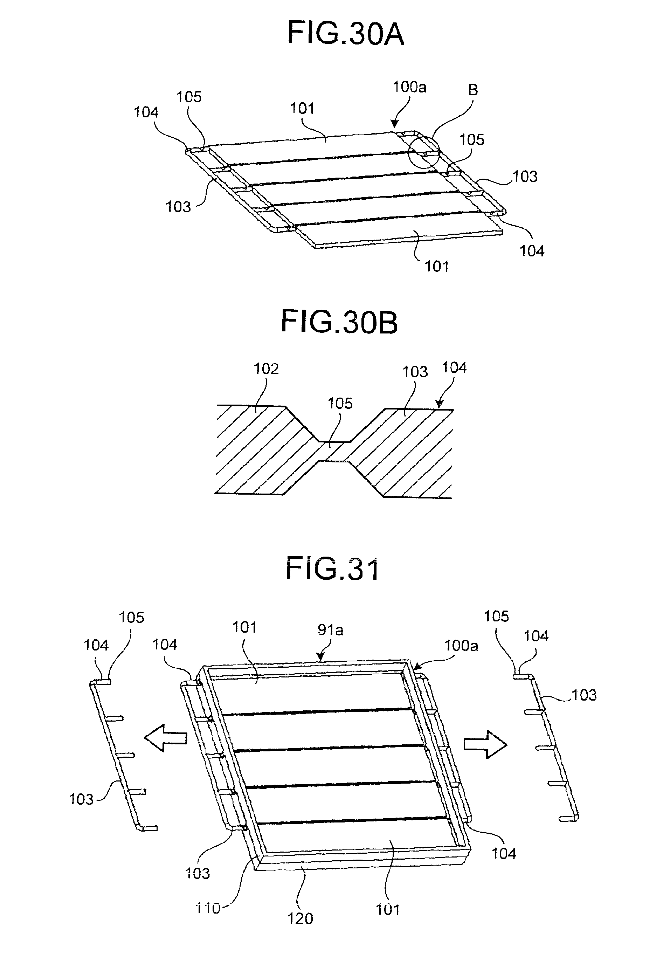

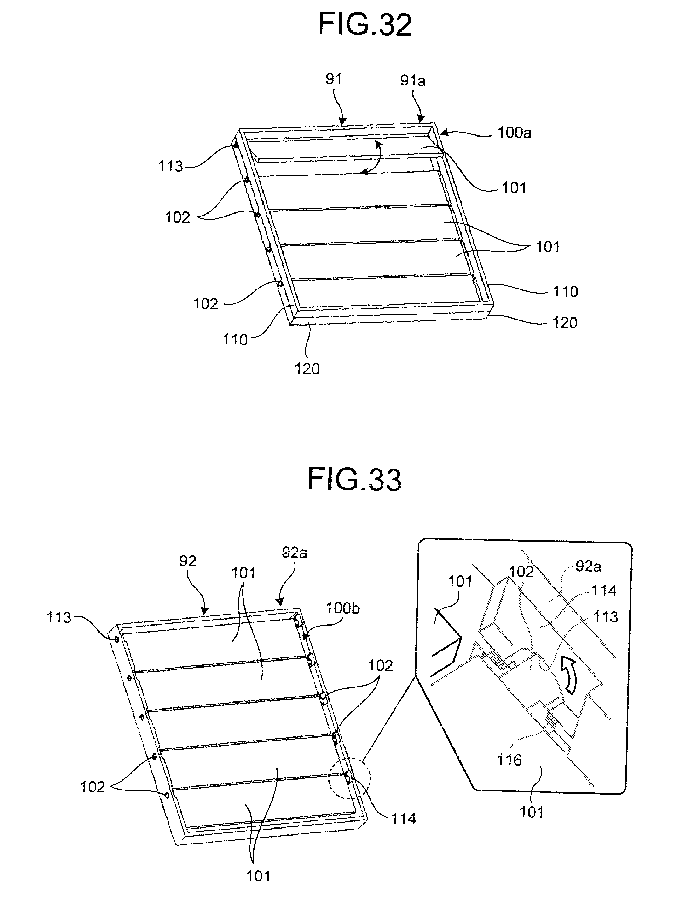

Now, referring to FIGS. 29 to 32, the fabricated structure of a backflow prevention device 91 will be described. FIG. 29 is an exploded perspective view illustrating the fabricated structure of a backflow prevention device. FIG. 30A is a perspective view illustrating a flap assembly. FIG. 30B is an enlarged view illustrating the part B of FIG. 30A. FIG. 31 is a perspective view illustrating a method for fabricating a backflow prevention device. Furthermore, FIG. 32 is a perspective view illustrating the fabricated structure of a backflow prevention device. Note that in the fabricated structure of the backflow prevention device 91, the same components as those of the fabricated structure of the aforementioned backflow prevention device 90 are designated with the same symbols and will not be repeatedly described.

As illustrated in FIG. 29, the backflow prevention device 91 is composed of a frame case 91a of the backflow prevention device 91 that is made up of a first frame case 110 and a second frame case 120, and a flap assembly 100 disposed between the two first and second frame cases 110 and 120.

That is, the backflow prevention device 91 includes a flap assembly 100a into which a plurality of (five in FIG. 29) flaps 101 are integrally molded. Then, the flap assembly 100a thus molded in one piece is sandwiched between the upper and lower frame cases, i.e., the first frame case 110 and the second frame case 120, which have been separately molded. More specifically, the first frame case 110 and the second frame case 120 which form the frame case 91a are joined together. This results in the semicircular holes 112 of the first frame case 110 and the semicircular holes 122 of the second frame case 120 being also joined together. It is thus possible to form the rotation holes 113 for rotatably supporting (see FIG. 22) the rotational shafts 102 of the plurality of flaps 101.

As illustrated in FIG. 30A, the flap assembly. 100a is integrally molded in one piece so that the plurality of flaps 101 are separately disposed in advance in parallel to each other. The flap assembly 100a is also integrally molded, on its both sides, with the connection frame 103 having the connecting portion 104 while connecting between the rotational shafts 102 secured to the flaps 101.

That is, the first frame case 110 and the second frame case 120 are joined together, thereby allowing the semicircular holes 112 of the first frame case 110 and the semicircular holes 122 of the second frame case 120 to be also joined together. This in turn makes it possible to form the rotation holes 113 (see FIG. 22) for fitting over the rotational shafts 102 of the flaps 101.

Furthermore, a joint portion 105 (FIG. 30B) between the rotational shafts 102 of the flaps 101 forming the flap assembly 100a and the connecting portion 104 of the connection frame 103 is reduced in thickness. This is to facilitate the separation of the connecting portion 104 of the connection frame 103 from the rotational shafts 102 of the flaps 101.

Note that as described above, the flaps 101 that constitute the backflow prevention device 91 are to be made of an ABS (Acrylonitrile Butadiene Styrene) material. However, the backflow prevention device 91 is configured such that the rotational shafts 102 of the flaps 101 are connected to the connection frame 103 via the joint portion 105 (FIG. 30B) which has been reduced in thickness. Accordingly, the flaps 101 may also be formed of a moldable metal-based material, such as a zinc alloy or aluminum, other than ABS.

Furthermore, as illustrated in FIGS. 31 and 32, to fabricate the backflow prevention device 91, the flap assembly 100a is disposed between the first frame case 110 and the second frame case 120 which form the frame case 91a. Now, like the method of fabricating the backflow prevention device 90, the rotational shafts 102 of the flap assembly 100a are fitted into the respective semicircular holes 112 of the first frame case 110 and the respective semicircular holes 122 of the second frame case 120 (FIG. 22).

Then, the rotational shafts 102 of the flaps 101 and the connecting portion 104 of the connection frame 103 are separated. More specifically, the connecting portion 104 for joining together the rotational shafts 102 of the flaps 101 and the connection frame 103 is cut at the joint portion 105 (FIG. 30B) , thereby removing the connection frame 103 from the flap assembly 100a.

As such, as illustrated in FIG. 32, it is possible to fabricate the backflow prevention device 91 in which the plurality of flaps 101 are opened and closed about the rotational shafts 102 that are rotatably supported in the rotation holes 113 of the frame case 91a. That is, since the plurality of flaps 101 are divided into individual flaps 101, the flaps 101 are capable of opening and closing about the rotational shafts 102.

As described above, according to the backflow prevention device 91, the plurality of flaps 101 are separately arranged in parallel to each other, and integrally molded into the flap assembly 100a that has the connection frame 103 for connecting between one ends of the rotational shafts 102 of the plurality of flaps 101. Furthermore, the rotational shafts 102 of the flaps 101 and the connecting portion 104 of the connection frame 103 are provided with the joint portion 105 that is reduced in thickness. When the backflow prevention device 91 is fabricated, it is thus possible to easily cut the connecting portion 104 of the connection frame 103, thereby reducing the number of fabrication steps.

### Fabricated Structure of Backflow Prevention Device 3

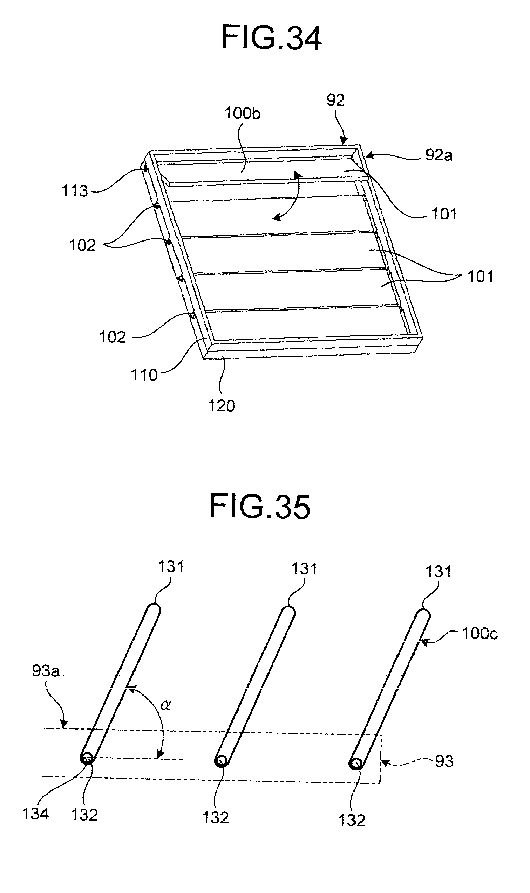

Now, referring to FIGS. 33 and 34, the fabricated structure of a backflow prevention device 92 will be described. FIG. 33 is an explanatory perspective view illustrating the fabricated structure of a backflow prevention device. FIG. 34 is a perspective view illustrating the fabricated structure of a backflow prevention device. Note that in the fabricated structure of the backflow prevention device 92, the same components as those of the fabricated structures of the aforementioned backflow prevention devices 90 and 91 are designated with the same symbols and will not be repeatedly described.

As illustrated in FIG. 33, the backflow prevention device 92 has a fabricated structure in which a flap assembly 100b having the plurality of flaps 101 arranged separately in parallel to each other is integrally molded with a frame case 92a for rotatably supporting the rotational shafts 102 of the flaps 101.

The frame case 92a rectangular in shape is constructed as a square frame case that has a width enough to accommodate the number of flaps 101 employed. At predetermined positions of the frame case 92a, there are provided rotation holes 113 for rotatably supporting the rotational shafts 102 secured to the plurality of flaps 101. That is, the frame case 92a is provided on its inner side with a rectangular recessed portion 114. At about the center of the recessed portion 114, the rotation hole 113 is formed to rotatably support one rotational shaft 102 of the flap 101.

Furthermore, one end of the flaps 101 (the right side in FIG. 33) or the proximal end side of the rotational shafts 102 is provided with a joint portion 116 for connecting between the rotational shafts 102 and the inner side of the frame case 92a. This joint portion 116 serves as a molded portion for connecting between the frame case 92a and the rotational shafts 102 of the flaps 101. That is, part of the joint portion 116 provided on the rotational shafts 102 of the flaps 101 can be cut, thereby rotatably supporting the rotational shafts 102 of the flaps 101 with respect to the frame case 92a.

Here, as illustrated in FIG. 33, to fabricate the backflow prevention device 92, the rotational shafts 102 of the flaps 101 are rotated in the clockwise direction (as indicated by the arrow in FIG. 33), thereby causing the frame case 92a and the rotational shafts 102 of the flaps 101 to be separated at a point of the joint portion 116. That is, the joint portion between the flaps 101 and the connection frame 103 is separated by rotating the rotational shafts 102 of the flaps 101, thereby allowing the flaps 101 integrated with the frame case 92a to serve as single flaps 101. Furthermore, the plurality of flaps 101 can be freely opened or closed about the rotational shafts 102 that are rotatably supported by in rotation holes 113 of the frame case 92a.

That is, as illustrated in FIG. 34, it is possible to fabricate the backflow prevention device 90 in which the plurality of flaps 101 open and close about the rotational shafts 102 that are rotatably supported in the rotation holes 113 of the frame case 90a. Since the plurality of flaps 101 are divided into individual flaps 101, the flaps 101 are capable of opening and closing about the rotational shafts 102.

As described above, according to the fabricated structure of the backflow prevention device 92, the plurality of flaps 101 are separately arranged in parallel to each other and integrally molded into the flap assembly 100 that has the connection frame 103 for connecting between one ends of the rotational shafts 102 of the plurality of flaps 101.

Furthermore, the connecting portion of the connection frame 103 has only to be cut to incorporate the flaps 101 into the frame case 92a. The plurality of flaps 101 thus can be made independent of the flap assembly 100b easily by rotating the rotational shafts 102 of the flaps 101. This structure eliminates the necessity of distinguishing between the front and rear side of the flaps 101 upon assembly of the flaps 101 into the frame case 92a. It is thus possible to reduce mistakes in assembling the flaps 101 or an increase in the number of steps resulting from an increase in the number of flaps 101 to be employed.

### Fabricated Structure of Backflow Prevention Device 4

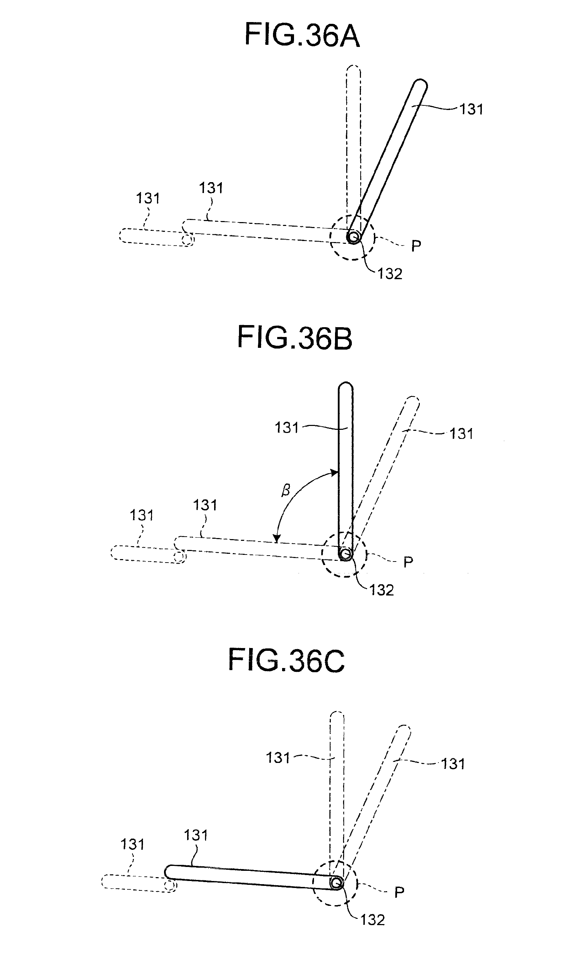

Now, referring to FIG. 35, FIGS. 36A to 36C, and FIGS. 37A to 37C, the fabricated structure of a backflow prevention device 93 will be described. Here, FIG. 35 is a side view illustrating the outer appearance of the backflow prevention device. FIG. 36A illustrates the position of a flap when being fabricated, FIG. 36B illustrates the position of a flap when being opened, and FIG. 36C depicts the position of a flap when being closed.

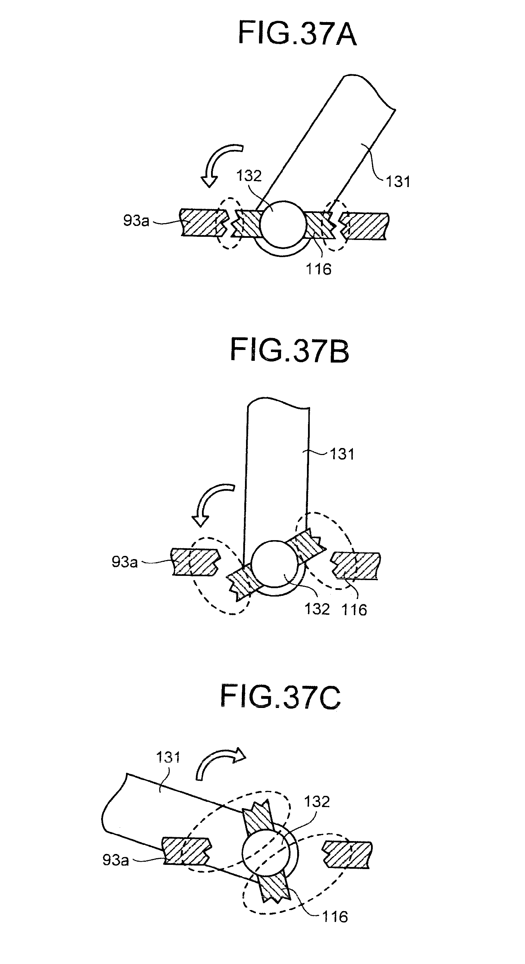

Furthermore, FIG. 37A is an enlarged view illustrating the portion P in FIG. 36A, FIG. 37B is an enlarged view illustrating the portion P in FIG. 36B, and FIG. 37C is an enlarged view illustrating the portion P in FIG. 36C. Note that in the fabricated structure of the backflow prevention device 93, the same components as those of the fabricated structure of the aforementioned backflow prevention device 92 are designated with the same symbols and will not be repeatedly described.

As illustrated in FIG. 35, the backflow prevention device 93 includes a flap assembly 100c with a frame case 93a that is provided with flaps 131 arranged separately in parallel to each other. That is, the frame case 93a is integrally molded with the flap assembly 100c in one piece, allowing rotation holes 134 to rotatably support rotational shafts 132 of the flaps 131 that constitute the flap assembly 100c.

Furthermore, when molding the flap assembly 100c having the plurality of flaps 131 in one piece, the flaps 131 are located diagonally at a predetermined angle α (generally about 60 degrees). Note that the flaps 131 will be opened and closed in the range of a predetermined angle β (FIG. 36A).

More specifically, as illustrated in FIG. 36A, the flaps 131 of the flap assembly 100c and the frame case 93a are integrally molded in one piece at a predetermined angle α (a tilt angle of about 60 degrees). At this time, there is formed a burr portion (portion P in FIG. 36A) around the rotational shafts 132 of the flaps 131 and at the joint portion 116 with the frame case 93a (FIG. 33).

Here, as illustrated in FIG. 36B, rotating the flaps 131 to open causes the rotational shafts 132 also to rotate, and the burr portion of the rotational shafts 132 (portion P in FIG. 37B) to move away from the burr portion of the frame case 93a (the dotted line portion) as indicated by the arrow (in the clockwise direction). This does not cause the burr portion of the rotational shafts 132 (portion P in FIG. 37B) and the burr portion of the frame case 93a (the dotted line portion) to interfere with each other. As a result, the flaps 131 can be smoothly rotated.

Furthermore, as illustrated in FIG. 36C, when the flaps 131 are closed, the flaps 131 being closed causes the burr portion of the rotational shafts 132 (portion P in FIG. 37C) to move away from the burr portion of the frame case 93a (the dotted line portion) as indicated by the arrow (in the clockwise direction). Accordingly, as in FIG. 37B, the burr portion of the rotational shafts 132 (portion P in FIG. 37C) and the burr portion of the frame case 93a (the dotted line portion in the figure) will not interfere with each other. As a result, the flaps 131 can rotate smoothly when closed.

As described above, the backflow prevention device 93 is fabricated such that the plurality of flaps 131 are integrally molded into the flap assembly 100c and diagonally positioned at a predetermined angle α (about 60 degrees) when molded. This structure makes it possible to prevent the rotational malfunction of the flaps 131 caused by, for example, burrs that could occur at the joint potion (the joint portion 116) between the rotational shafts 132 of the flaps 131 and the frame case 93a. As a result, the rotational shafts 132 can be rotated smoothly when the flaps 131 are opened or closed.

### Method for Fabricating Backflow Prevention Device

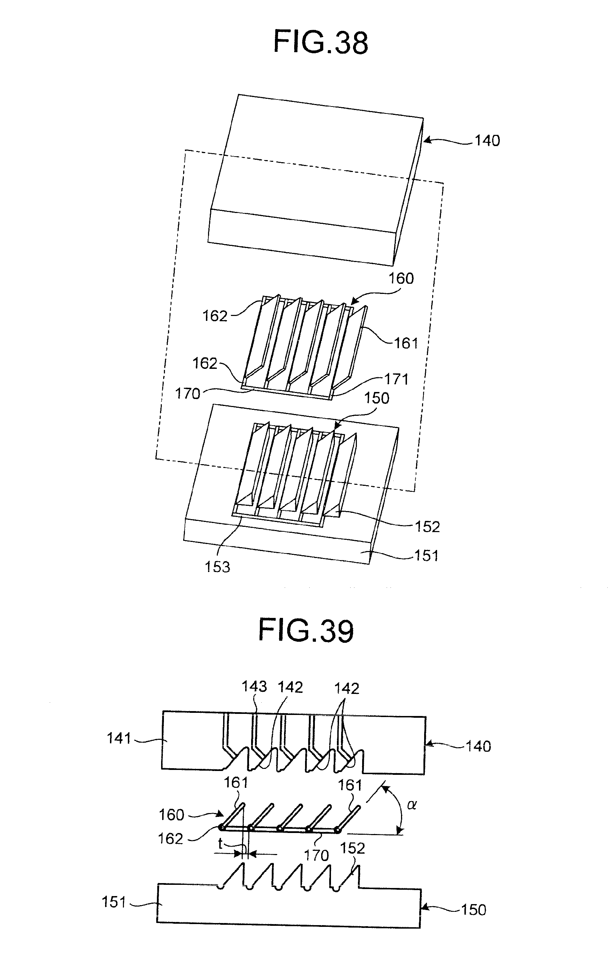

Now, referring to FIGS. 38 to 40, a method for fabricating a backflow prevention device will be described. Here, FIG. 38 is an explanatory exploded perspective view illustrating the molded structure of a backflow prevention device. FIG. 39 is an exploded perspective view illustrating the molded structure of a backflow prevention device.

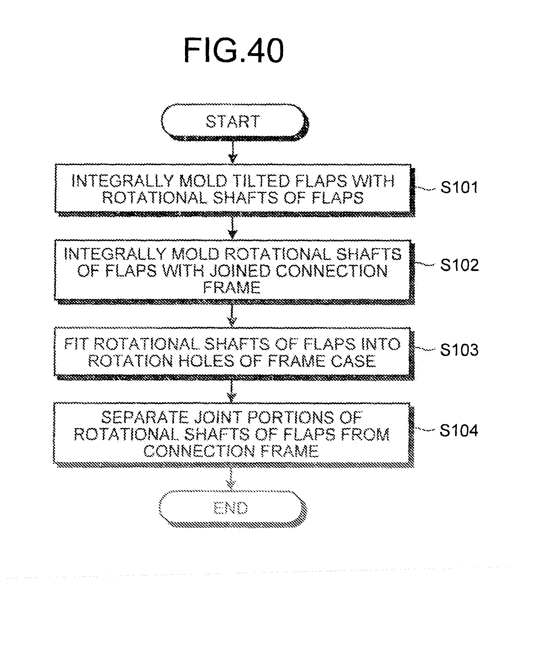

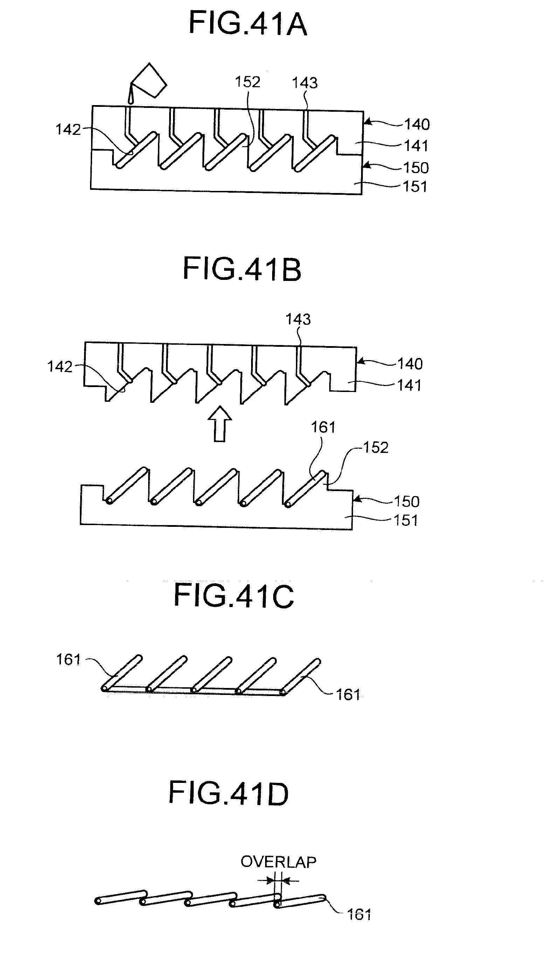

Furthermore, FIG. 40 is an explanatory flowchart of the steps of a method for fabricating a backflow prevention device. FIGS. 41A and 41B each are an explanatory view illustrating a method for fabricating a backflow prevention device. FIG. 41C is a cross sectional view illustrating the shape of a flap assembly. Furthermore, FIG. 41D is a cross sectional view illustrating the shape of a flap assembly. Here, a description will be made assuming that the backflow prevention device is fabricated using an assembly machine for fabricating predetermined molded components.

As illustrated in FIGS. 38 and 39, a method for fabricating a backflow prevention device employs a mold 140 with sawtooth recessed portions 142 formed in a main body 141 and a mold 150 also with sawtooth projected portions 152 formed in a main body 151. The recessed portions 142 formed in the main body 141 of the mold 140 are each provided at part thereof with respective gates 143 through which a liquid molded material (plastic material) flows.

Furthermore, the main body 151 of the mold 150 is provided with a rectangular passage portion 153 formed to mold a pair of connection frames 170 that have a connecting portion 172 to rotational shafts 162 of flaps 161. As illustrated in the figure, with the mold 140 and the mold 150 combined together, a flap assembly 160 having the flaps 161 tilted at a predetermined angle and the connection frame 170 connected to the flaps 161 can be integrally molded in one piece.

That is, the plastic material flowing through the gates 143 of the mold 140 stays and hardens in the cavity formed between the recessed portions 142 of the mold 140 and the projected portions 152 of the mold 150. As such, the material is molded as the flap assembly 160 that includes the flaps 161 oriented at a predetermined tilt angle. On the other hand, likewise, the plastic material flowing through the gates 143 of the mold 140 stays and hardens in the passage portion 153 formed in the mold 150. It is thus possible to mold the connection frame 170 which has the rotational shafts 162 of the flaps 161 and a connecting portion 171.

That is, it is thus possible to provide a molded flap assembly 160 which has the flaps 161 oriented at a predetermined angle and the connection frame 170 connected to the rotational shafts 162 of the flaps 161.

Here, the flap assembly 160 that is molded as the flaps 161 oriented at a predetermined angle has a reduced gap t (FIG. 39) between the flaps 161. Accordingly, when the flaps 161 are closed, the distal end portion of one flap 161 will overlap the proximal end portion of the next flap 161. That is, it is possible to prevent a gap through which airflow passes between the adjacent flaps 161.

Now, referring to the flowchart of FIG. 40 and FIGS.41A to 41D, a method for fabricating a backflow prevention device will be described in detail below.

As illustrated in the flowchart of FIG. 40, first, the plurality of diagonally tilted flaps 161 and the rotational shafts 162 secured to the flaps 161 are integrally molded in one piece (step S101). Then, the flaps 161 and the connection frame 170 having the connecting portion 171 for connecting to the rotational shafts 162 of the flaps 161 are integrally molded in one piece (step S102).

More specifically, as illustrated in FIG. 41A, the mold 140 and the mold 150 are clamped together, and then, a plastic material is allowed to pass through the gates 143. The flaps 161, which are arranged diagonally in parallel to each other, and the connecting portion 171 for connecting between the connection frame 170 and the rotational shafts 162 secured to the plurality of flaps 161 are thereby molded in one piece.

As illustrated in FIG. 41B, the plurality of flaps 161 and the connection frame 170 connected with the rotational shafts 162 of the flaps 161 diagonally arranged in parallel to each other can be integrally molded as the flap assembly 160.

Next, the rotational shafts 162 of the plurality of flaps 161 molded in one piece in the aforementioned step S102 are fitted into the rotation holes 134 (FIG. 35) of the frame case 93a (step S103). The rotational shafts 132 of the flaps 161 can thus be rotated freely with respect to the rotation holes 134 of the frame case 93a.

Then, the joint portion between the rotational shafts 162 of the flaps 161 and the connection frame 170 is separated by cutting (step S104). More specifically, the rotational shafts 162 of the flaps 161 that form the flap assembly 160 are separated by cutting from the connecting portion 171 of the connection frame 170.

It is thus possible to fabricate a flap assembly 260 having the flaps 161, as illustrated in FIG. 41C, that are arranged diagonally at a predetermined angle. Here, as described above, the flap assembly 160 molded as the flaps 161 oriented at a predetermined angle provides a reduced gap t (FIG. 39) between the flaps 161.

Accordingly, when the flaps 161 are closed, the distal end portion of one flap 161 overlaps the proximal end portion of the next flap 161 (FIG. 41D), thereby allowing for preventing a gap through which airflow passes between the adjacent flaps 161.

As described above, in the method for fabricating a backflow prevention device, the plurality of flaps 131 are molded to orient at a predetermined tilt angle. At the same time, the rotational shafts 132 secured to the flaps 131 and the connection frame 170 connected thereto are integrally molded in one piece as the flap assembly 160. Then, the connection frame 170 is separated from the flap assembly 160 by cutting at the connecting portion 171. This allows for eliminating a gap between the adjacent flaps 131 when the plurality of flaps 131 are closed. As a result, it is possible to ensure that the surrounding air is prevented from flowing in through the flaps 131 of the backflow prevention device.

### Problems with Conventional Techniques

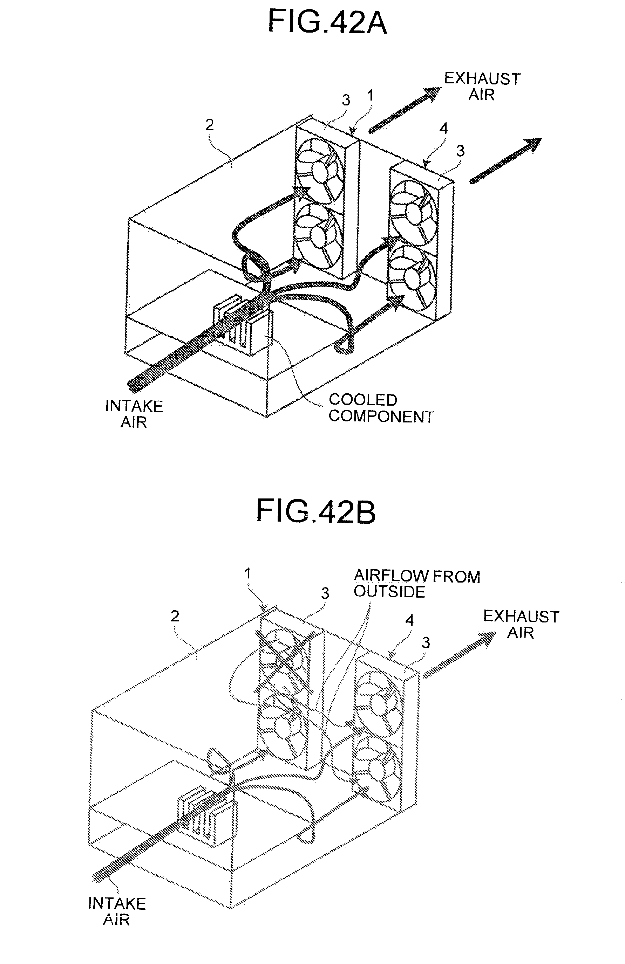

Now, a description will be briefly made to a backflow prevention device according to a conventional technique. Here, the problems with a cooling apparatus that includes no backflow prevention device will be first described. FIG. 42A is an explanatory view illustrating a conventional cooling apparatus. FIG. 42B is an explanatory view illustrating a conventional cooling apparatus when a cooling fan has failed.

As illustrated in FIG. 42A, a cooling apparatus 4 that includes a plurality of (four in FIG. 42A) cooling fans 3 is provided in a case 2 that forms a server 1. Rotating the cooling fans 3 of the cooling apparatus 4 causes airflow of intake and exhaust air to occur from the intake openings, provided on the front of the case 2, to the exhaust openings. This airflow can be used to cool the components in the case.

Here, when all the cooling fans 3 work normally, a sufficient amount of air comes in through the air inlet, so that the inflow of air can be drawn and expelled equally by the four cooling fans 3. In this case, for example, the amount of airflow per one cooling fan 3 is 4.5 m/min if the total amount of air drawn through the air inlet is 18 m/min.

On the other hand, as illustrated in FIG. 42B, when a cooling fan 3 has failed, the surrounding air also flows in through the air channel of the failed cooling fan 3. Thus, the amount of airflow per one cooling fan 3 increases from 4.5 m/min to about 5.5 m/min. However, the amount of intake air is reduced from 18 m/min to 13.5 m/min due to a decrease in cooling capacity of the failed cooling fan 3. As such, when a cooling fan 3 has failed, control had conventionally to be provided to operate the other functional cooling fans 3 at higher speeds in order to compensate for a decrease in the amount of intake air, while the amount of intake air was actually reduced.

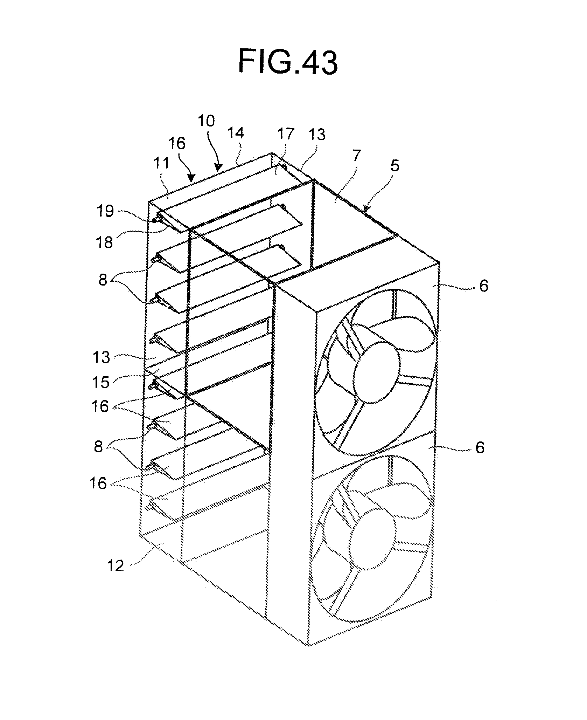

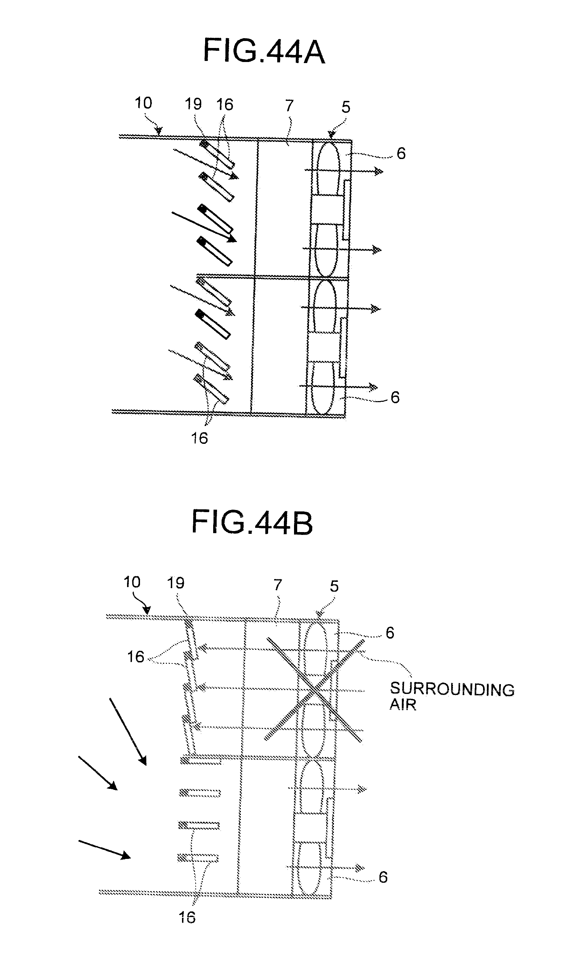

Furthermore, a backflow prevention device 10 has been conventionally employed to prevent the surrounding air from being drawn backwards through the air channel when a cooling fan has failed. Now, referring to FIGS. 43 and 44A and 44B, a cooling apparatus 5 with the conventional backflow prevention device 10 will be outlined below. FIG. 43 is an explanatory view illustrating the cooling apparatus 5 that has the conventional backflow prevention device 10. FIG. 44A is a cross sectional view illustrating the inside of the backflow prevention device. Furthermore, FIG. 44B is a cross sectional view illustrating the inside of the backflow prevention device.

As illustrated in FIG. 43, the case 2 that constitutes the server 1 (FIG. 42A) includes the cooling apparatus 5 having a plurality of cooling fans 6, and the backflow prevention device 10 near the cooling apparatus 5.

The cooling apparatus 5 includes the cooling fans 6 which are provided vertically, a duct case 7 divided by a partition plate 15, and the backflow prevention device 10 disposed in the front of the duct case 7. The backflow prevention device 10 is formed of a frame case 14 that has a top plate 11, a bottom plate 12, and a pair of side plates 13. Furthermore, the frame case 14 is provided therein with a plurality of flaps 16 for preventing backward airflow.

Furthermore, as illustrated in the figure, the frame case 14 includes rotation holes 8 formed to rotatably support rotational shafts 19 of the plurality of flaps 16. The flap 16 has a flat portion 17, elongated as a whole, and side plate portions 18 to which a pair of rotational shafts 19 is secured.

As illustrated in FIG. 44A, the air drawn through the cooling fans 6 is exhausted through the passageway that is opened by the rotational shafts 19 of the plurality of flaps 16 in the backflow prevention device 10. On the other hand, as illustrated in FIG. 44B, when a cooling fan 6 has failed in the cooling apparatus 5 and the surrounding air is drawn in through that cooling fan 6, the plurality of flaps 16 provided in the backflow prevention device 10 are closed. It is thus possible to prevent inflow of the surrounding air, thereby preventing a drop in cooling capacity of the cooling apparatus 5.

As such, the cooling apparatus 5 with the backflow prevention device 10 can use the plurality of flaps 16 provided in the backflow prevention device 10 to prevent inflow of the surrounding air even when a cooling fan 6 has failed. This in turn allows for preventing a drop in cooling capacity of the cooling apparatus 5.

However, the aforementioned conventional backflow prevention device 10 employed heavy flaps 16 in order to reduce their vibrations which would have occurred due to fluttering of light flaps 16 when a small amount of air was supplied by the cooling fans 6.

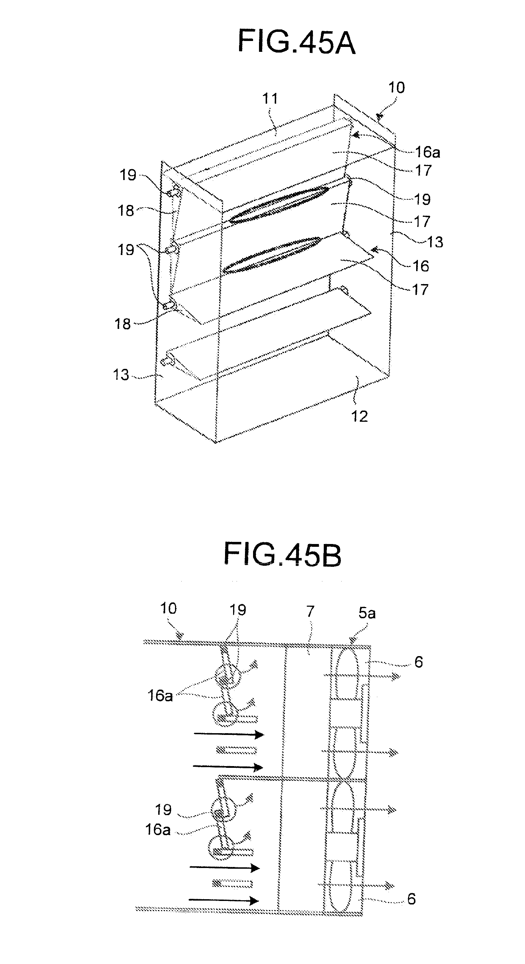

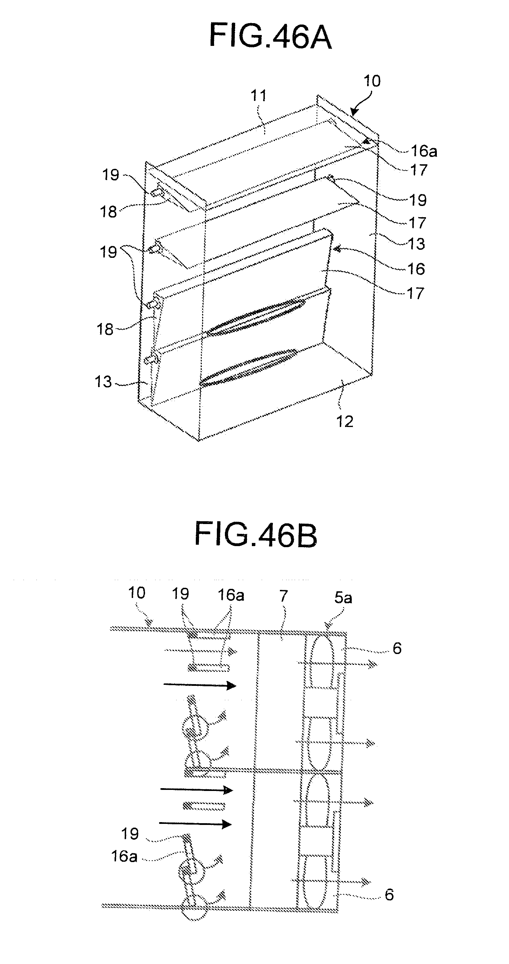

Now, a description will be made to problems with the flaps provided in a backflow prevention device. FIG. 45A is a perspective view illustrating the inside of a backflow prevention device. FIG. 45B is a cross sectional view illustrating the inside of a cooling apparatus. Furthermore, FIG. 46A is a perspective view illustrating the inside of a backflow prevention device. FIG. 46B is a cross sectional view illustrating the inside of a cooling apparatus.

That is, as illustrated in FIGS. 45A and 45B, light-weight flaps 16a employed in the backflow prevention device 10 flutter and vibrate due to airflow. This causes the lower side of an upper flap 16a provided above an adjacent lower flap 16a to be brought into contact with the upper side of the latter one (circled in the figure), resulting in this contact causing vibration noises.

Furthermore, likewise, as illustrated in FIGS. 46A and 46B, light-weight flaps 16a employed in the backflow prevention device 10 flutter and vibrate due to airflow. This causes the lower side of an upper flap 16a provided above an adjacent lower flap 16a to be brought into contact with the upper side of the latter one (circled in the figure), resulting in this contact causing vibration noises.

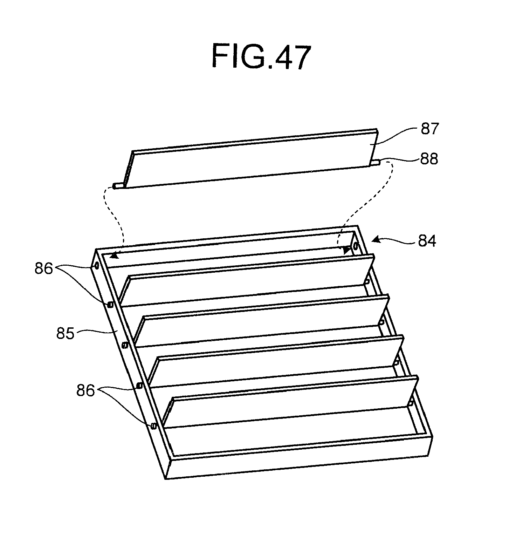

Now, a description will be made to problems with a method for fabricating a backflow prevention device according to a previously-proposed technique. FIG. 47 is an explanatory view illustrating a previously-proposed method for fabricating a backflow prevention device. As described above, such a backflow prevention device is fabricated by allowing a plurality of flaps to be rotatably incorporated into the frame case via rotational shafts.

That is, as illustrated in FIG. 47, a frame case 84 forming the backflow prevention device is formed in a vertically elongated square shape, and a pair of side plate portions 85 formed in the frame case 84 are provided with a plurality of (five in FIG. 47) rotation holes 86. Then, the rotation holes 86 of the pair of side plate portions 85 are rotatably fitted over rotational shafts 88 of flaps 87.

Here, to fabricate the flaps 87 provided in a frame case 90a of the conventional backflow prevention device, a mold having a flat mold region for forming the flaps 87 is used to fill in the mold region with a plastic material. Then, the plastic material filled and hardened in the mold region of the mold is used as the flaps 87.

However, in the previously-proposed method for fabricating a backflow prevention device, it is necessary to distinguish between the front and rear sides of the flaps 87 when the flaps 87 are assembled into the frame case 84. This would cause assembly errors or an increase in the number of steps resulting from an increase in the number of the flaps 87 to be employed.

An embodiment of the present invention can solve the problems of the previously-proposed technique and prevent vibration noises caused by vibrating flaps or flaps abutting against each other and collision noises made by flaps colliding with the frame case.

According to an embodiment of the present invention, it is possible to prevent vibration noises caused by vibrating and thereby fluttering flaps incorporated in the backflow prevention device and collision noises resulting from flaps abutting against the frame case.

## Claims

1. A backflow prevention device (20; 20a; 20b; 20c; 60) disposed between a heat-generating component (1c) that generates heat and an air supply unit (6) for supplying air to the heat-generating component (1c), the backflow prevention device (20; 20a; 20b; 20c; 60) comprising:
a plurality of flaps (30; 30a; 70) to be opened by airflow supplied from the air supply unit (6) and to be closed by gravity when the airflow stops;
a frame case (21; 61) that rotatably supports the plurality of flaps (30; 30a; 70); and
a connecting member (40; 50; 80) that connects between the plurality of flaps (30; 30a; 70).

2. The backflow prevention device (20a; 60) according to claim 1, wherein
the frame case (21; 61) has a plurality of rotation holes (25),
the plurality of flaps (30a; 70) each have first shafts (33; 75) fitted into the plurality of rotation holes (25) and a second shaft (34; 76) located at a different position from the first shafts (33; 75), and
the connecting member (50; 80) includes a connection plate having rotation holes (53; 82a) for rotatably supporting the second shafts (34; 76).

3. The backflow prevention device (20a; 60) according to claim 2, wherein each of the plurality of flaps (30a; 70) has a rectangular shape with an upper side (31a), a lower side (31b), and two lateral sides (32; 72), the first shafts (33) being provided on the respective two lateral sides (32; 72) near the upper side (31a), the second shaft (34; 76) being provided on one of the two lateral sides (34; 76) near a middle between the upper side (31a) and the lower side (31b).

4. The backflow prevention device (20b; 20c) according to claim 1, 2, or 3, wherein the connecting member (40; 50) connects between the flaps (30; 30a) except a flap (30b, 30c) located near either an upper side or a lower side of the frame case (21).

5. The backflow prevention device (20b; 20c) according to claim 1, 2, or 3, wherein the frame case (21) is provided with another flap other than the plurality of flaps (30; 30a), the another flap being not connected with the connecting member (40; 50).

6. An electronic apparatus (1a) comprising:
a heat-generating component (1c) that generates heat;
an air supply unit (6) for supplying air to the heat-generating component (1c); and
a backflow prevention device (20; 20a; 20b; 20c; 60) disposed between the heat-generating component (1c) and the air supply unit (6),
wherein the backflow prevention device (20; 20a; 20b;
20c; 60) comprises a backflow prevention device as claimed in any preceding claim.

7. A method for fabricating a backflow prevention device with rotational shafts (162) of a plurality of flaps (161) each arranged to be rotatable about a center of a rotation hole (134) of a frame case (93a), the method comprising:
integrally molding the rotational shafts (i62) of the plurality of flaps (161) with a connection frame (170) joined to the rotational shafts (162), the plurality of flaps (161) being oriented at a predetermined tilt angle;
fitting the rotational shafts (162) of the plurality of integrally molded flaps (161) into the respective rotation holes (134) of the frame case (93a); and
separating joint portions (171) between the rotational shafts (162) of the flaps (161) fitted into the rotation holes (134) of the frame case (93a) and the connection frame (170).
